# EUROPEAN PATENT SPECIFICATION

(11) **EP 0 466 025 B1**
(45) Date of publication and mention of the grant of the patent: **10.03.1999**
(21) Application number: 91111109.4
(22) Date of filing: 04.07.1991
(51) Int. Cl.: G03F 7/075

(54) **Resist material, method for the production of the same and process of forming resist patterns using the same**
Resistmaterial, Methode zu seiner Herstellung und Verfahren zum Herstellen von Resistbildern mit diesem Material
Matériau de photoréserve, méthode pour produire ledit matériau et procédé pour former un motif sur ledit matériau de photoréserve

(30) Priority: 06.07.1990 JP 177257/90; 27.11.1990 JP 320781/90
(43) Date of publication of application: 15.01.1992
(73) Proprietor: NIPPON TELEGRAPH AND TELEPHONE CORPORATION, Shinjuku-ku, Tokyo 163-19 (JP)
(72) Inventor: Tanaka, Akinobu, Kanagawa (JP); Ban, Hiroshi, Atsugi-shi, Kanagawa (JP); Nakamura, Jiro, Isehara-shi, Kanagawa (JP); Kimura, Takao, Mito-shi, Ibaraki (JP); Kawai, Yoshio, Isehara-shi, Kanagawa (JP)
(74) Representative: Bühling, Gerhard, Dipl.-Chem.

(56) References cited:
- EP-A- 315 954
- EP-A- 422 570
- IEEE TRANSACTIONS ON COMPONENTS,HYBRIDS,AND MANUFACTURING vol. 11, no. 4, November 1988, NEW YORK US pages 611 - 617; M.CAGAN AND D.RIDLEY: 'A Photo-Patternable Stress Relief Material for Plastic Packaged Integrated Circuits'

## Description

The present invention relates to a resist material for use in lithography, for example, in the production of integrated circuits and more particularly to a resist material for two layer resists, which material can reproduce negative patterns with high accuracy and has high resistance to oxygen plasma etching (high O₂RIE resistance). Also, the present invention relates to a method of producing such a resist material, as well as to a process of forming resist patterns with such a resist material.

Positive type photoresists composed of novolak resin and naphthoquinonediazide as a photosensitizer are featured by having high sensitivity, high resolution, and high solubility in alkaline solutions and have recently been used widely in the field of lithography. Resists are generally grouped into two types, one single layer resists and the other two layer resists (including silylated ones) having a top layer and a bottom layer. While the single layer resists are advantageous that they require simple processes more attention is paied to the two layer resists which can be formed into thin films in order to compensate for decrease in optical focal distance accompanying exposure with high resolution using a short wavelength radiation. In other words, the two layer resists can make the best of the performance of the exposure device used although the processes associated therewith are somewhat complicated.

In the conventional two layer resist system (B. J. Lin, Solid State Technol., 26 (5), 105 (1983)), patterns with a high aspect ratio can be obtained by anisotropically etching the substrate by oxygen plasma etching (O₂RIE) using a thin film of the resist formed on the substrate as a mask. Hence, much importance is given to the resistance of the resist to O₂RIE. Generally, those materials which form oxides upon O₂RIE, typically those containing silicon (Si), are considered to have high resistance to O₂RIE. In this respect, photoresists currently put into practice are defective in that they have poor resistances to O₂RIE because they contain no silicon component. In order to avoid the defects, resist materials based on polysiloxane have heretofore been proposed. This type of resist materials generally have low glass transition temperatures. Because of this, there arise various severe problems in adaptability to the processes. More particularly, dusts tend to collect on the material during the processing, the thickness of the film prepared from the material is difficult to be controlled, and the developability of the material decreases due to the deformation of patterns upon development.

For example, conventional resist materials contain novolak resin, a silicon compound and an acid generator, and the silicon compound is rendered alkali-insoluble as a result of condensation with an acid generated by the acid generator upon exposure to high energy radiation (cf., D. R. McKean, et al., "A highly etch resistant, negative resist for Deep-UV and electron beam lithography", SPIE Vol. 1262 Advances in Resist Technology and Processing VII, pp. 110 (1990) ; and T. Ueno, et al., "Chemical Amplification Negative Resist Systems Composed of Novolac, Silanols, and Acid Generators", SPIE Vol. 1262, Advances in Resist Technology and Processing VII, pp.26 (1990)). The resist materials have low Si contents as low as 12 % or less resulting in that they have low oxygen plasma resistance and pattern formation with high precision is difficult therewith.

Another conventional resist material composed of a polysiloxane and an acid generator (crosslinking agent) crosslinks with OH groups upon exposure, resulting in decreased solubility in aqueous alkali solutions (cf. The 51st Scientific Lecture Meeting of Japanese Applied Physics Association, Preliminary Print No. 28a-PC-8 (1990)). Thus, the utilization of crosslinking reaction fails to give acceptable resolution of patterns.

EP-A-0 422 570 discloses ultraviolet light sensitive photoinitiator compositions which may include radiation-sensitive epoxy functionalized organosilicon glass resins which can be prepared by reacting HO-Si-terminated glass resins with an excess of glycido-containing mono-or polyfunctional alkoxysilicon compounds in solutions. Therefore, no hydrolysis is involved in this procedure.

Few resist materials can be used for a wide variety of high energy radiations. Particularly, both few are usable for UV and deep UV which greatly differ in energy level one from another.

Therefore, there is a keen demand for alkali-developable type resist materials which have high glass transition temperatures and high resistance to O₂RIE and can be used for various high energy radiations.

An object of the present invention is to provide a resist material which is alkali-developable, and has a high glass transition temperature, and high resistance to O₂-RIE.

Another object of the present invention is to provide a method of preparing a resist material which is of an alkali-developable type, has a high glass transition temperature, and high resistance to O₂-RIE.

Still another object of the present invention is to provide a process of forming resist patterns using such a resist material.

Under the circumstances, extensive investigations have been made to achieve the aforementioned objects, and as a result it has now been found that the use of a polymer having siloxane bonds as a skeletal structure increases resistance to O₂-RIE, that the introduction of a ladder-type chemical structure into the molecule of the polymer by using polyfunctional alkoxide as a raw material increases the glass transition temperature of the polymer, and that the introduction of silanol groups into the polymer makes it possible for the polymer to condense with dehydration in the presence of an acid upon exposure to high energy radiation to insolubilize the polymer, thus enabling the formation of negative patterns.

According to the first aspect of the present invention, a resist material comprises:
(a) a polysiloxane comprising hydroxyl groups in the polymer having partial structural units represented by formulae (1) to (3), respectively, below; 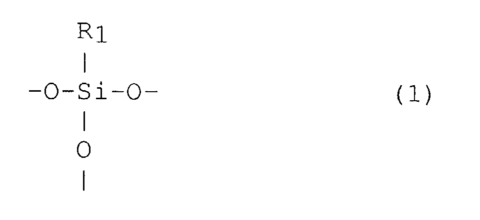 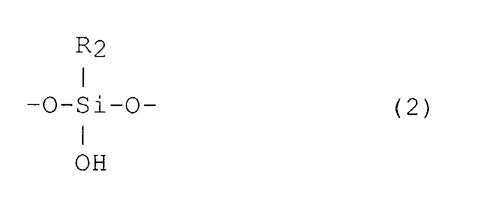 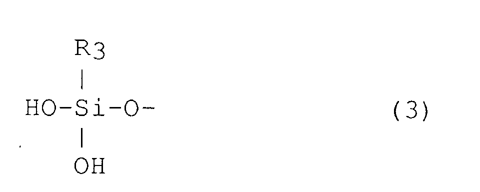 wherein R₁, R₂ and R₃, which are the same or different, each represent an organic group, a part or all of a multiplicity of organic groups represented by R₁, R₂ or R₃, respectively, have an oxirane ring, and the partial structural units represented by formulae (1), (2) and (3), respectively, are connected to each other so as to complete siloxane bonds; and
(b) an acid generator.

Here, R₁, R₂ and R₃, which are the same or different, each may be an alkyl group, an alkenyl group, a cycloalkyl group, a phenyl group, or a 4-tetrahydrophthalic anhydride group, preferably a 3-glycidoxypropyl group, a 2-(3,4-epoxycyclo-hexyl)ethyl group, an ethyl group, a methyl group, a phenyl group, or a 4-tetrahydro-phthalic anhydride group, and more preferably a 2-(3,4-epoxycyclohexyl)ethyl group or a phenyl group. The abundance of the groups represented by R₁, R₂ and R₃ and having an oxirane ring may be about 20 to 100 % by mole based on total groups represented by R₁, R₂ and R₃. Preferably, the polysiloxane may be a weight average molecular weight of about 800 to about 10,000.

In the aforementioned resist material, the acid generator may be one selected from the class consisting of:
(i) an onium salt represented by formula (I), (II) or (III) below;

   R'N₂⁺MXn⁻ (I)

   (R')₂I⁺MXn⁻ (II)

   (R')₃S⁺MXn⁻ (III)

   wherein R' is an unsubstituted or substituted aromatic group, and MXn⁻ is a group selected from the group consisting of BF₄⁻, PF₆⁻, AsF₆⁻, and SbF₆⁻;
   (ii) a halomethyltriazine;
   (iii) tetrabromobispohenol A;
   (iv) a nitrobenzyl ester compound; and
   (v) a trifluoromethanesulfonate compound.

The acid generator may preferably be diphenyl-4-thiophenoxyphenylsulfonium hexafluorophosphate. The acid generator may be contained in an amount of about 0.5 to about 20 % by weight based on the weight of the resist material.

The aforementioned resist material may contain a spectral sensitizer, preferably phenathiazine. The resist material may also contain an organic polymer having a hydroxyl group. This organic polymer may be one selected from the group consisting of novolak resin, phenol resin, pyrogallol-acetone polymer and polyvinylphenol. The organic polymer may be contained in an amount of no more than about 10 % by weight.

The aforementioned resist material may contain an epoxy compound. The epoxy compound may be one selected from the group consisting of ethylene glycol diglycidyl, epoxy resin, epoxystyrene, and epoxybutane. The amount of the epoxy compound may be no more than about 5 % by weight based on the weight of the resist material.

According to the second aspect of the present invention, a resist material comprises:
(a') a polysiloxane as defined above comprising an alkoxysilane having an oxirane ring alone, and optionally a polysiloxane free of an oxirane ring; and
(b) an acid generator.

According to the third aspect of the present invention, a method of producing a resist material, comprises the steps of:
hydrolyzing an alkoxysilane having an oxirane ring to form a hydrolyzate;
condensing with dehydration the hydrolyzate to form a polysiloxane; and
mixing the polysiloxane with an acid generator.

According to the fourth aspect of the present invention, a method of producing a resist material, comprises the steps of:
hydrolyzing an alkoxysilane having an oxirane ring and an alkoxysilane free of an oxirane ring to form a hydrolyzate;
condensing with dehydration the hydrolyzate to form a polysiloxane; and
mixing the polysiloxane with an acid generator.

According to the fifth aspect of the present invention, a process of forming resist patterns comprises the steps of:
applying an organic polymer on a substrate to form a bottom layer on the substrate;
coating a resist material as defined above on the bottom layer to form a top layer, thus forming a two layer resist on the substrate;
prebaking the two layer resist;
imagewise exposing the prebaked two layer resist with high energy radiation to obtain an exposed two layer resist having an exposed portion of the top layer and an unexposed portion of the top layer;
postbaking the exposed two layer resist to render the exposed portion of the top layer insoluble in an alkali developer;
developing the exposed two layer resist with an alkali developer to remove the unexposed portion of the top layer while retaining the insolubilized, exposed portion of the top layer on the first layer to form space corresponding to the unexposed portion of the top layer; and
dry etching the bottom layer using the remaining exposed portion of the top layer as a mask to remove the bottom layer in a region beneath the space corresponding to the unexposed portion of the top layer.

Here, the postbaking may preferably be performed at a temperature lower than that at which the prebaking is carried out.

The resist material of the present invention is a mixture of the polysiloxane and the acid generator, and optionally the organic polymer having a hydroxyl group in the polymer, and the silanol groups contained therein can efficiently dehydrate and condensate upon exposure to high energy radiation with the acid generated by the acid generator serving as a catalyst so that it can give rise to highly sensitive, alkali-developable, nonswelling negative-type resists. Because it contains silicon, the resist material of the invention has high resistance to oxygen plasma etching or dry etching; it can be used as a top layer of two layer resists. Its feasibility in two layer resists enables the formation of fine patterns in a width of no larger than 0.5 µm, even as small as 0.25 µm, in a high aspect ratio, e.g., up to at least about 10.

The above and other objects, effects, features and advantages of the present invention will become more apparent from the following description of embodiments thereof taken in conjunction with the accompanying drawings.
Fig. 1 is cross-sectional views illustrating a process of forming resist patterns according to the present invention;
Fig. 2 is a schematic perspective view showing a resist pattern formed according to the process of the present invention;
Fig. 3 is a chart illustrating an infrared absorption spectrum of the alkali-soluble polysiloxane prepared according to Preparation Example 6 of the present invention;
Fig. 4 is a chart illustrating a ²⁹Si-NMR spectrum of the alkali-soluble polysiloxane prepared according to Preparation Example 6 of the present invention;
Fig. 5 is a graph illustrating the relationship between the sensitivity and storage stability of the resist material prepared according to Preparation Example 6 of the present invention and the amount of polyvinylphenol contained therein, the sensitivity being evaluated initially and after 6 month standing; and
Fig. 6 is a graph illustrating the relationship between the sensitivity of the resist material prepared according to Preparation Example 6 of the present invention and the amount of diphenyl-4-thiophenoxyphenylsulfonium hexafluorophosphate contained therein.

The polysiloxane constituting the resist material of the present invention is a polysiloxane obtained by the hydrolysis and condensation with dehydration of either 1) one or more polyfunctional alkoxysilanes having an oxirane ring (hereafter, sometimes referred to also as oxirane-containing alkoxysilanes), or 2) one or more oxirane-containing alkoxysilanes and one or more alkoxysilanes free of an oxirane ring (hereafter, sometimes referred to also as oxirane-free alkoxysilanes), and some or all of the pendant groups derived from the alkoxysilanes in the polysiloxane contain an oxirane ring. The term oxirane ring is also referred to as epoxy group.

More specifically, the polysiloxane used in the resist material of the invention has partial structural units represented by formulae (1) to (3), respectively, below;

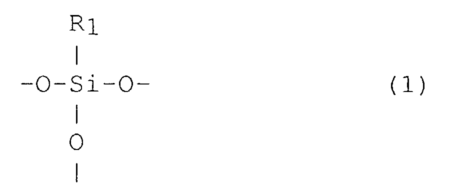

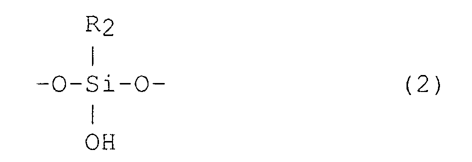

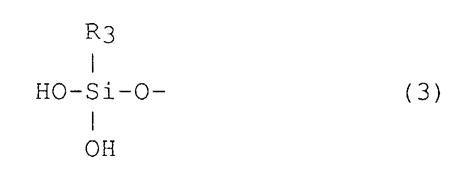

In the above formulae, R₁, R₂ and R₃, which are the same or different, each represent an organic group such as an aliphatic hydrocarbon group, an alicyclic hydrocarbon group or an aromatic hydrocarbon group. The partial structural units represented by formulae (1), (2) and (3), respectively, are connected to each other so as to complete siloxane bonds. A part or all of a multiplicity of groups represented by R₁, R₂ and R₃, respectively, have an oxirane ring. In other words, some or each of the organic side chain groups or pendant groups of the polysiloxane, which are derived from the alkoxysilanes used as a starting material for the production thereof, contain an oxirane ring.

The polysiloxane contains typically the following ladder-type structure;

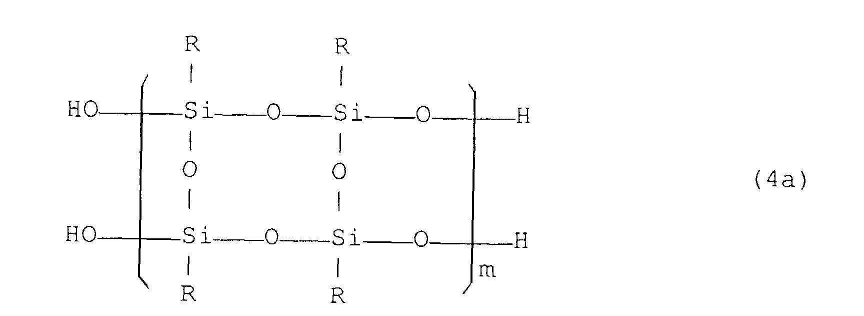

In formula (4a) above, m = 1 to 10, and a multiplicity of R's, which are the same or different, each has the same meaning as R₁, R₂ or R₃.

In addition to the above, the polysiloxane may contain incomplete ladder-type structures represented by formulae (4b), (4c), (4d) and (4e), respectively, which correspond to those ladder-type structures in which some of the siloxane bonds;

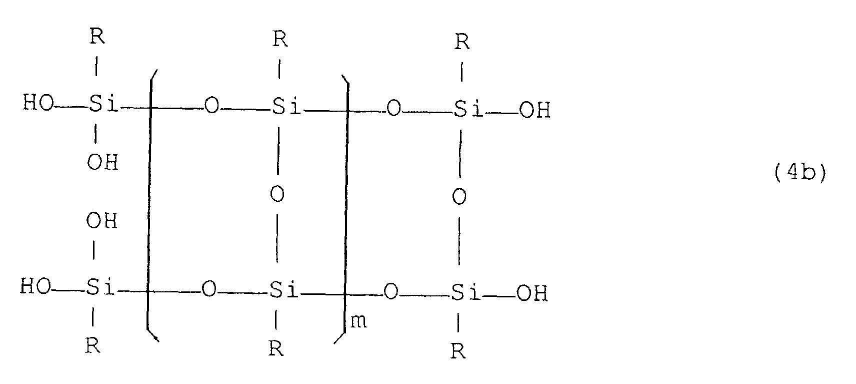

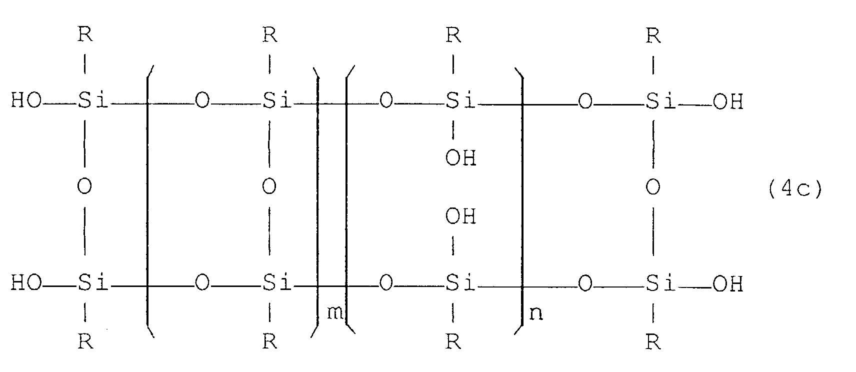

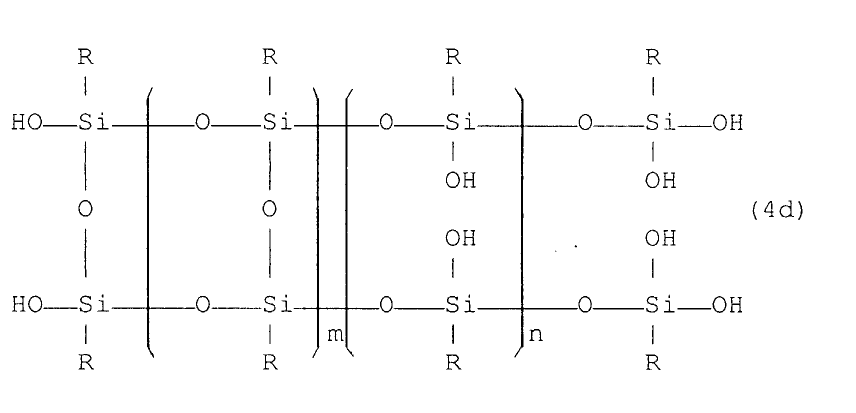

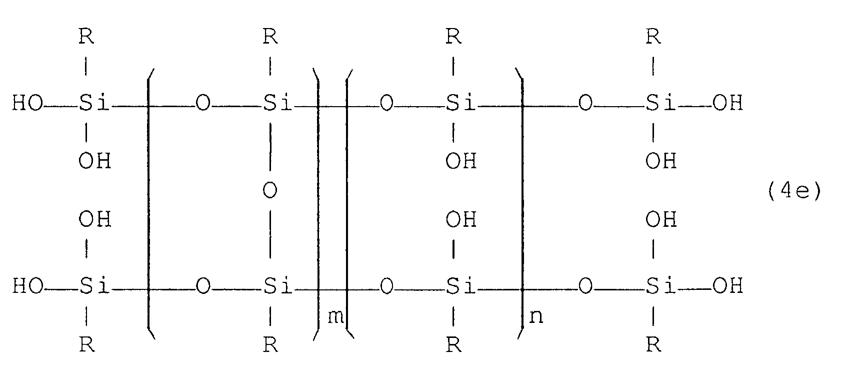

In formulae (4b) to (4e) above, m and n satisfy the following conditions;
m = 1 to 10, n = 1 to 10, and m + n ≦ 10, and a multiplicity of R's, which are the same or different, each has the same meaning as R₁, R₂ or R₃.

Examples of the aliphatic hydrocarbon group represented by R₁, R₂ or R₃ include an alkyl group preferably having 1 to 6 carbon atoms, such as a methyl group, an ethyl group, a propyl group, a hexyl group, etc.; an alkenyl group preferably having 2 to 4 carbon atoms such as a vinyl group, an allyl group, etc.; an acetoxy group, and the like.

Examples of the alicyclic hydrocarbon group represented by R₁, R₂ or R₃ include a cycloalkyl group preferably having 5 or 6 carbon atoms, such as a cyclohexyl group.

The aromatic hydrocarbon group represented by R₁, R₂ or R₃ is, for example, a phenyl group.

The aforementioned organic groups represented by R₁, R₂ or R₃ may have one or more substituents selected from, for example, fluorine; an amino group; a substituted amino group such as a 2-aminoethylamino group, an N-methylamino group, an N-allyl-N-(2-aminoethyl)amino group, an N-allyl-N-glycidylamino group, or an N,N-glycidylamino group; a mercapto group; a cyano group; a methacryloxy group, an acetoxy group, a 4-tetrahydrophtahlic anhydride group, and a 4-tetrahydrophthalic acid group.

Specific examples of the groups represented by R₁, R₂ or R₃ include a 3-glycidoxypropyl group, a 2-(3,4-epoxycyclohexyl)ethyl group, a 3-(N-allyl-N-glycidyl)aminopropyl group, a 3-(N,N-diglycidyl)-aminopropyl group, a methyl group, an ethyl group, a propyl group, a hexyl group, a vinyl group, an allyl group, an amino group, a 3-(2-aminoethylamino)propyl group, an N-methylaminopropyl group, a 3-aminopropyl group, a 3-[N-allyl-N-(2-aminoethyl)]aminopropyl group, a 3-(N,N-diglycidyl)aminopropyl group, a 3-mercaptopropyl group, a 2-cyanoethyl group, a 3-methacryloxypropyl group, an acetoxy group, a 4-tetrahydrophthalic anhydride group, a 4-tetrahydrophthalic acid group, etc.

In the case where the polysiloxane is prepared by hydrolysis and condensation with dehydration of one or more of the oxirane-containing alkoxysilanes, it can be prepared generally by the following method. First, a specified alkoxysilane or alkoxysilanes is or are dissolved in an alcohol such as ethanol, and water and a catalyst such as hydrochloric acid are added to the resulting solution. The catalyst may be omitted, if desired. While this reaction proceeds usually at room temperature, the reaction may be carried out with heating at about 100°C, for example. After a predetermined time (e.g, for 2 to 10 hours), the reaction mixture is introduced in water to form precipitates. After being filtered, the product is dried usually at 50°C. The product in this stage may be put into practical use, or it may be introduced in a suitable solvent (e.g., dimethylacetamide (DMAc)) containing an alkali catalyst or the like and allowed to react further when a polymer with a higher molecular weight is desired. It is also effective to heat the product in a bulk at about 120 to 140°C, for example, so that the condensation reaction can proceed further. Because the alkoxysilanes produce silanols during this reaction and the silanol groups are introduced in the polymer, the resulting polysiloxane dissolve in aqueous alkali solutions.

The catalyst which can be used for the production of the polysiloxane is not limited particularly and includes, for example, acid catalysts such as hydrochloric acid, hydrofluoric acid, nitric acid, sulfuric acid, acetic acid, and formic acid, and alkali catalysts such as ammonia, sodium hydroxide, potassium hydroxide, and calcium hydroxide.

The polysiloxane obtained by hydrolysis and condensation with dehydration of the alkoxysilanes generally has silanol groups at terminals thereof, and there is a possibility that the silanol groups condensate with each other to change the characteristics of the polysiloxane with time. This disadvantage can be avoided by adding a silylating agent to the reaction system to substitute the silanol groups by nonreactive substituents. However, the silylation must be controlled carefully in view of the solubility of the polysiloxane in alkalis. Suitable examples of the silylating agent include trimethylsilyl chloride, hexamethyldisilazane, etc.

Specific examples of the oxirane-containing alkoxysilane include 3-glycidoxypropyltrimethoxysilane, 3-glycidoxypropylmethyldimethoxysilane, 2-(3,4-epoxycyclohexyl)ethyltrimethoxysilane, 3-(N-allyl-N-glycidyl)aminopropyltrimethoxysilane, 3-(N,N-diglycidyl)aminopropyltrimethoxysilane, 3-glycidoxypropyltriethoxysilane, 3-glycidoxypropylmethyldiethoxysilane, 2-(3,4-epoxycyclohexyl)-ethyltriethoxysilane, 3-(N-allyl-N-glycidyl)aminopropyltriethoxysilane, 3-(N,N-diglycidyl)aminopropyltriethoxysilane, etc.

Polysiloxanes obtained by copolymerization of one or more of the oxirane-containing alkoxysilanes with one or more of the oxirane-free alkoxysilanes may also be used in the present invention. The copolymerization may be carried out under substantially the same hydrolysis and dehydration conditions as the aforementioned polymerization (hydrolysis and condensation with dehydration) of the oxirane-containing alkoxysilane(s).

The oxirane-free alkoxysilanes are not limited particularly and any conventional alkoxysilanes which have no oxirane ring may be used. Specific examples thereof include dimethoxydimethylsilane, diethoxydimethylsilane, dimethoxymethyl-3,3,3-trifluoropropylsilane, diethoxydivinylsilane, diethoxydiethylsilane, 3-aminopropyldiethoxymethylsilane, 3-(2-aminoethylaminopropyl)dimethoxymethylsilane, dimethoxymethylphenylsilane, diethoxymethylphenylsilane, dimethoxydiphenylsilane, diethoxydiphenylsilane, tris(2-methoxyethoxy)vinylsilane, methyltrimethoxysilane, ethyltrimethoxysilane, 3,3,3-tripropyltrimethoxysilane, methyltriethoxysilane, 3-(N-methylaminopropyl)trimethoxysilane, methyltris(2-aminoethoxy)silane, triacetoxyvinylsilane, triethoxyvinylsilane, ethyltriethoxysilane, 2-mercaptoethoxysilane, 3-(2-aminoethylaminopropyl)-trimethoxysilane, phenyltrimethoxysilane, 2-cyanoethyltriethoxysilane, allyltriethoxysilane, 3-glycidoxypropyltrimethoxysilane, propyltriethoxysilane, hexyltrimethoxysilane, 3-aminopropyltriethoxysilane, 3-methacryloxypropyltrimethoxysilane, methyltripropoxysilane, phenyltriethoxy-silane, 3-(N-allyl-N-(2-aminoethyl))aminopropyltrimethoxysilane, 3-(N-allyl-N-glycidyl)aminopropyltrimethoxysilane, 3-(N,N-diglycidyl)aminopropyltrimethoxysilane, 4-trimethoxysilyltetrahydrophthalic anhydride, 4-triethoxysilyltetrahydrophthalic anhydride, 4-triisopropoxysilyltetrahydrophthalic anhydride, 4-trimethoxysilyltetrahydrophthalic acid, 4-triethoxysilyltetrahydrophthalic acid, 4-triisopropoxysilyltetrahydrophthalic acid, tetramethoxysilane, tetraethoxysilane, tetrabutoxysilane, n-butyltrichlorosilane, dimethyldichlorosilane, ethyltrichlorosilane, methyltrichlorosilane, phenyltrichlorosilane, trichlorovinylsilane, diphenyldichlorosilane, etc. Among these compounds, particularly preferred are phenyltriethoxysilane, phenyltrimethoxysilane, methyltriethoxysilane and tetraethoxysilane in view of ease of getting starting materials thereof, high reactivity, and desirable characteristics of products thereof.

Particularly preferred oxirane-containing alkoxysilane is 2-(3,4-epoxycyclohexyl)ethyltriethoxysilane, and phenyltriethoxysilane is particularly preferred as the oxirane-free alkoxysilane. It is preferred to use these in combination.

The polysiloxane used in the resist material of the present invention usually has a weight average molecular weight of about 800 to about 10,000. If the molecular weight is lower than about 800, the sensitivity is insufficient while the molecular weight exceeding about 10,000 results in poor stability with time. The abundance of oxirane ring in the polysiloxane is about 20 to about 70 % by mole based on total pendants. If it is lower than about 20 % by mole, the polysiloxane has too low a solubility in alkali developers. If the abundance of oxirane ring exceeds about 70 % by mole, the polymer has a glass transition temperature below 50°C. Generally, higher silicon (Si) content is more advantageous in order to obtain higher resolution, and usually it is preferred to use no less than about 15 % by weight of S: based on the weight of the polysiloxane.

While the higher the glass transition temperature of resist materials is, the higher resolution they have and they usually must have a glass transition temperature of at least 50°C, preferably 100°C, it is generally difficult to obtain polysiloxanes having a glass transition temperature higher than about 150°C. Hence, it is preferred that the polysiloxane used in the invention has a glass transition temperature within the range of about 100 to 150°C.

The polysiloxane used in the present invention has an optical transmission of no lower than 90 % at 248 nm in a thickness of 1 µm. When phenyltriethoxysilane is used in an amount of 50 mole % in the production of the polysiloxane, the polysiloxane has an optical transmission of no lower than 70 %, and therefore it is hopeful for a resist material for excimer lasers. It is important to copolymerize phenyltriethoxysilane in order to increase the glass transition temperature, Tg, and its composition is determined depending on optical transmission and solubility in alkali of the resulting polymer. If the amount of phenyltriethoxy-silane added is above 80 % by mole, or the abundance of phenyl group as pendant in the polysiloxane is above 80 % by mole, the solubility of the polysiloxane in an aqueous alkali solution decreases greatly so that alkali development is difficult to be performed. This is presumed due to the fact that epoxy groups have higher affinities for water than phenyl groups do. Preferably, the abundance of phenyl group, or the amount of phenylalkoxysilane to be added, is 30 to 80 % by mole.

For example, when a mixture of 2-(3,4-epoxycyclohexyl)ethyltrimethoxysilane as the oxirane-containing alkoxysilane and phenyltriethoxysilane as the oxirane-free alkoxyxilane are reacted, a polysiloxane having the following ladder-type structure is obtained.

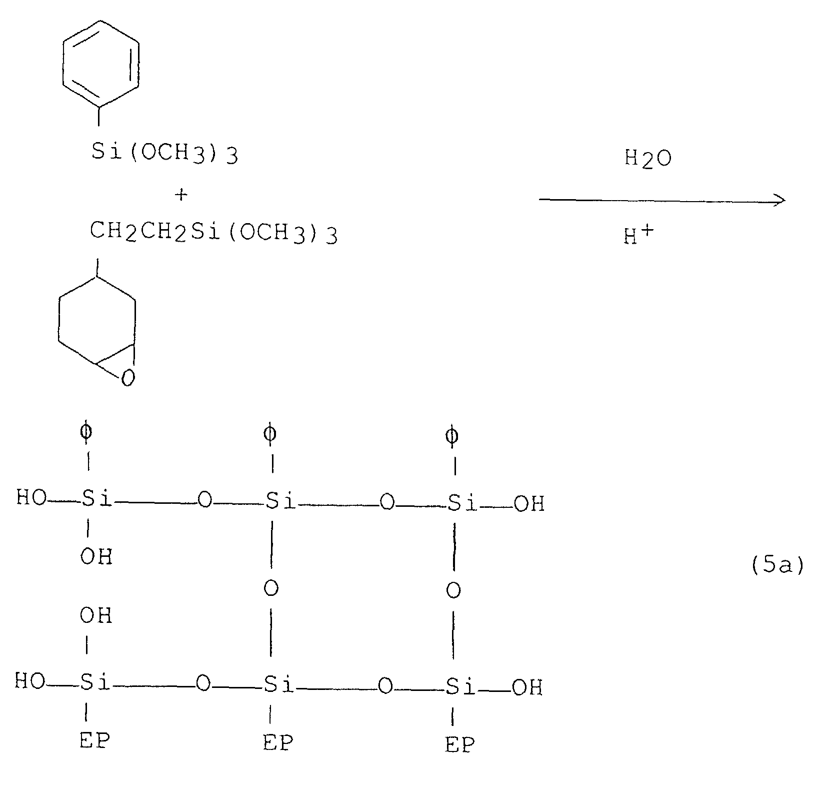

In formula (5a) above, EP represents a 2-(3,4-epoxycyclohexyl)ethyl group, and φ represents a phenyl group. Any φ may be interexchanged for any EP and vice versa.

Also, the resulting polysiloxane may contain any of the following incomplete ladder-type structures represented by formulae (5b), (5c), (5d) and (5e), respectively,

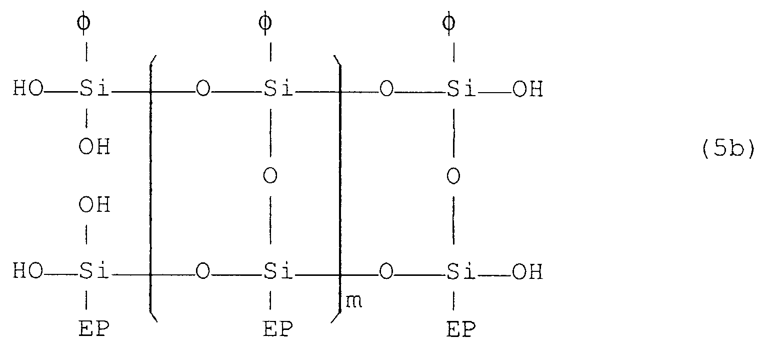

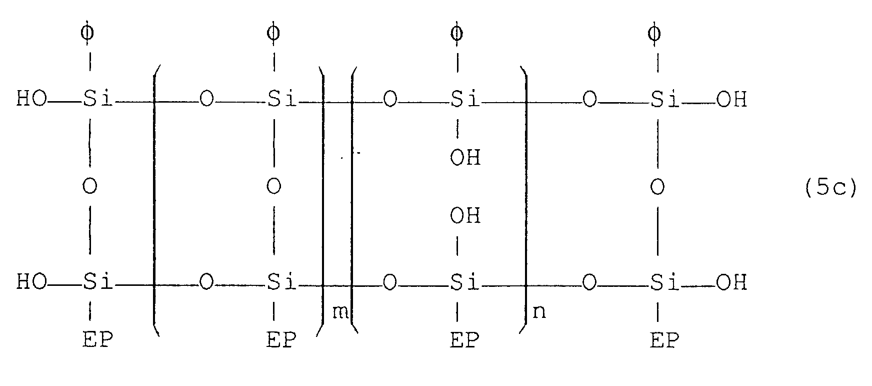

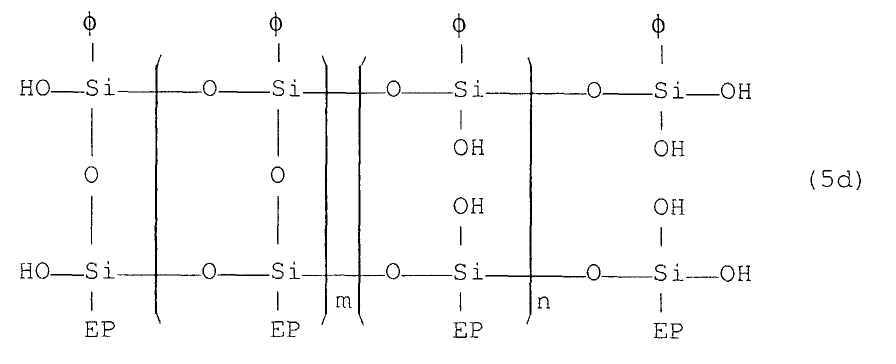

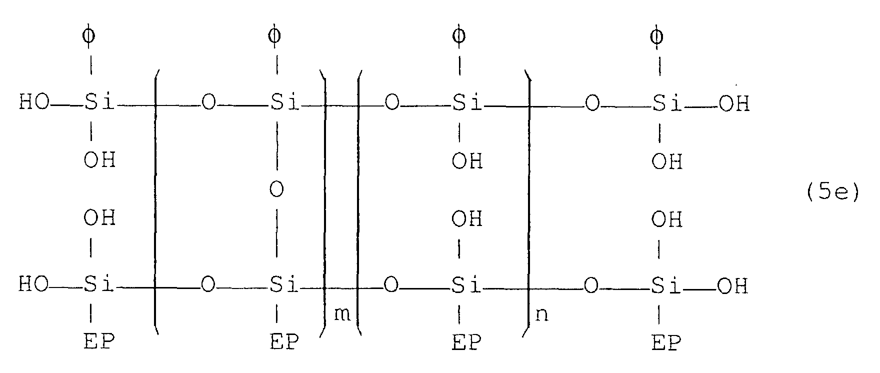

In formulae (5b) to (5e) above, EP represents a 2-(3,4-epoxycyclohexyl)ethyl group, φ represents a phenyl group. Any φ may be interexchanged for any EP and vice versa, and m and n satisfy the following conditions
m = 1 to 10, n = 1 to 10, and m + n ≦ 10.

Resist materials composed mainly of polysiloxane may be combined with a suitable sensitizer and put to various applications. However, orthonaphthoquinone type sensitizers have increased absorption at wavelengths no longer than 300 nm and in addition do not fade with irradiation of light; they are unsuitable for resist materials for use in lithography using, as a light source, radiation with wavelengths in the region of deep ultraviolet rays such as excimer lasers (e.g., KrF excimer laser). Accordingly, in the present invention, acid generators are used as a sensitizer. Since silanol groups remaining in the polysiloxane dehydrate and condensate efficiently in the presence of the acid generated from the acid generator as a catalyst, the amount of the acid generator to be added may be small, resulting in reduced optical absorption in the deep ultraviolet region.

The acid generator used in the present invention is not limited particularly and may include onium salts represented by the following general formulae (I), (II) and (III), respectively, below;

R'N₂⁺MXn⁻ (I)

(R')₂I⁺MXn⁻ (II)

(R')₃S⁺MXn⁻ (III)

wherein Ar or a multiplicity of (R')'s, which are the same or different, each represent an aromatic group or a substituted aromatic group, for example, a phenyl group, a naphthyl group, etc. which may be substituted with a t-butyl group, a methoxy group, a phenoxy group, a thiophenoxy group or the like; and MXn⁻ represents a member selected from the group consisting of BF₄⁻, PF₆⁻, AsF₆⁻, and SbF₆⁻ (e.g., diphenyl-4-thiophenoxyphenylsulfonium hexafluorophosphate), triflate compounds (e.g., bis(t-butylphenyl)iodonium triflate, triphenylsulfonium triflate, etc.), halomethyltriazines (e.g., dibromomethyltriazine, 2,4-bis(trichloromethyl)-6-phenyl-1,3,5-triazine, 2,4,6-tris(trichloromethyl)-1,3,5-triazine, etc.), tetrabromobisphenol A, nitrobenzyl ester compounds (e.g., 2,6-dinitrobenzyl tosylate). While the acid generators include those having low sensitivities to ultraviolet rays with wavelengths no shorter than 300 nm, such low-sensitive acid generators can also be used with simultaneous addition of a spectral sensitizer such as phenathiazine.

Among the aforementioned acid generators, one which gives the highest resolution and excellent storage stability of resist material is diphenyl-4-thiophenoxyphenylsulfonium hexafluorophosphate.

In the resist composition of the present invention, the acid generator also serving as a dissolution inhibitor for siloxane polymer in alkali solutions. The acid generator may be added usually in an amount of 0.5 to 20 % by weight. If this amount is below 0.5 % by weight, the amount of the acid generated is too small to make it possible to increase the sensitivity. On the other hand, if the amount exceeds 20 % by weight, the silicone content required for resist materials decreases to thereby deteriorate oxygen plasma etching resistance (O₂RIE resistance) and increase the absorption at 248 nm. Generally, preferred amount of the acid generator is about 5 % by weight.

The organic polymer having a hydroxyl group used in the present invention is not limited particularly, and various polymers such as novolak resins, phenol resins, pyrogallol-acetone polymers, polyvinylphenols may be used so far as they contain one or more hydroxyl groups in the molecule. These polymers are effective not only in improving the adhesion between the resist and the substrate but also in improving the storage stability of the resist. It is sufficient to add the organic polymer in an amount of 10 % by weight based on the polysiloxane.

The epoxy compound may be either aliphatic or aromatic. For example, ethylene glycol diglycidyl, Epikote 815 (epoxy resin, trade name for the product by Shell Co.), Epikote 1001 (trade name for epoxy resin produced by Shell Co.), epoxystyrene, epoxybutane, etc. can be used. Smaller epoxy equivalent of the epoxy compound is more advantageous because on that occasion the amount of the epoxy compound to be used can be reduced. When the amount of the epoxy compound is no larger than 5 % by weight based on the polymer (polysiloxane), it gives a great effect on the storage stability of the resist.

As the solvent, those resist solvents used commonly such as 2-ethoxyethyl acetate, ethyl lactate, and methoxy-2-propanol may be used.

Next, the process of forming patterns using the resist material of the present invention will be described below.

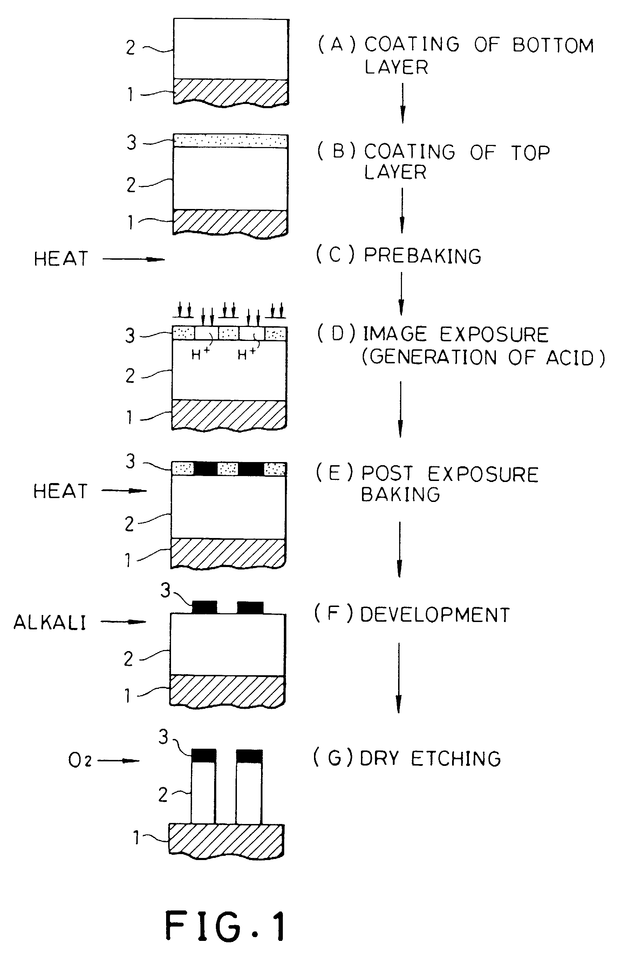

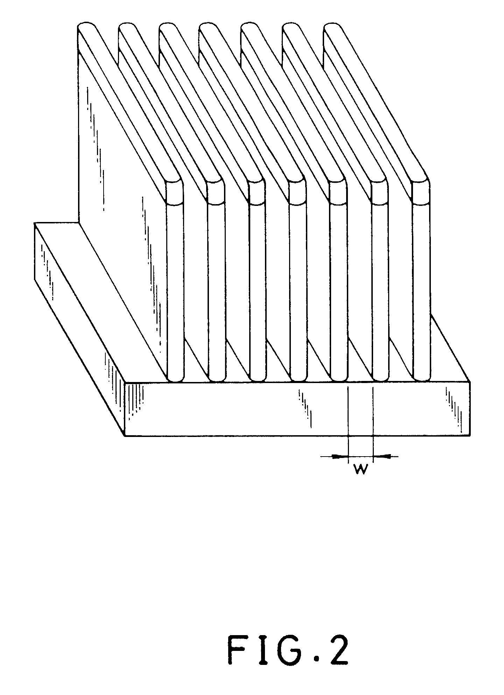

Fig. 1 is cross-sectional views illustrating the process of forming resist patterns according to the present invention, and Fig. 2 is a schematic perspective view showing the resist pattern formed according to Example 9 hereinbelow depicted based on scanning electron micrograph. Firstly, on a substrate 1 such as silicon wafer is formed a thin film 2 of the organic polymer (step A: coating of a bottom layer), and a thin film 3 of the resist composition of the invention is formed by coating on the organic polymer film 2 to complete a two layer structure on the substrate, of which structure the organic polymer film is a bottom layer 2, and the film of the resist composition of the invention is a top layer 3 (step B: coating of a top layer). Then, after prebaking (step C: prebaking), high energy radiation is irradiated onto the two layer structure to release acid from the acid generator contained in the resist composition (step D: imagewise exposure). The exposed resist is heated so that hydroxyl groups in the silanols in the top layer can condense with dehydration with the acid formed in the step C serving as a catalyst for the condensation reaction (step E: post exposure baking (hereafter, sometimes referred to as PEB)). As a result, the irradiated portion is rendered insoluble in an aqueous alkali solution. Thereafter, the resist material in the region other than the irradiated portion (i.e., unexposed region) is removed with an alkali developer (step F: development). Then, the lower layer is dry-etched using oxygen and using the resist material in the irradiated portion which has remained after the alkali development as a mask so that the organic polymer film beneath the resist material can be etched off (step G: dry etching), thus forming a resist pattern. As the organic polymer material, any type of organic polymer may be used so far as it can be etched with oxygen plasma. However, aromatic group-containing polymers are preferred because some resistance is required for the organic polymer when the substrate is dry-etched after the pattern formation using the etched (patterned) organic polymer as a mask.

In the process of forming patterns according to the present invention, diffusion of the acid generated by the acid generator can be prevented performing PEB at a temperature lower than that at which the prebaking is carried out, thus making it possible to form patterns with high resolution.

The top and bottom layers of the two layer resist of the invention, respectively, can be coated by a conventional coating method, for example, spin coating. The prebaking is performed usually at 100 to 120°C, preferably 105 to 110°C. The high energy radiation which can be used in the present invention include electron beams, X rays, deep UV rays, and UV rays. PEB can be carried out at 55 to 90°C, preferably 65 to 75°C. The dry etching can be performed using oxygen gas as an etching gas, for example, in a parallel flat plate type sputter-etching apparatus usually under the conditions of RF power being 0.1 to 0.2 W/cm², and O₂ gas partial pressure of 5 to 15 mTorr for 10 to 30 minutes.

In the aforementioned process of forming patterns, the use of PEB temperature lower than the prebaking temperature prevents the diffusion of acid generated by the acid generator, resulting in high resolution pattern formation.

Generally, resolution limits thus far reached using *g* line (436 nm) and *i* line (365 nm) from a high pressure Hg lamp are 0.5 µm and 0.4 µm, respectively. On the other hand, resolution limit is 0.3 µm when a KrF excimer laser (248 nm) is used. While it will be possible to fabricate generally 64 Mbit LSI and the like using a resist material having resolution limit of 0.3 µm the width of patterns actually obtained will be 0.35 µm when a resist material having resolution limit of 0.3 µm is used. There is a general impression that further increase in contrast would seem difficult to be obtained by approaches attempting to improve radiation source. The present invention is directed to improvement of resolution limit by improving resist materials. If resolution limit of 0.25 µm is reached it is beyond expectation to fabricate 256 Mbit practical devices. Thus, it is advantageous to realize fine patterns with features of 0.25 µm or less.

In fact, the resist material of the present invention has high optical transmittance (no lower than 70 %), high resolution, and high sensitivity (20 mJ/cm²). It also has high Si content (not lower than 17 % by weight) and high oxygen plasma resistance. As a result, it can be used as a material for forming the upper layer of a two layer resist. In KrF lithography, the resist material of the present invention gives rise to fine patterns with features of W = 0.25 µm or less at a high aspect ratio (about 3/0.25 = 12) as schematically illustrated in Fig. 2. With the resist material of the present invention, the fabrication of quarter micron or submicron super LSI is made possible. It is also possible to use the resist material of the invention in electron beam lithography and X ray lithography. In these cases, pattern formation with features of 0.2 µm or less is possible.

The process of forming patterns according to the present invention cause less undercut and thus enables subsequent formation of dry-etched patterns of the substrate with the feature of the substrate pattern being substantially the same as that of the resist because the resin material used has high O₂RIE resistance and narrow line-space width.

### EXAMPLES

The present invention will be explained in more detail by way of examples. However, it should not be understood that the present invention is limited thereto.

### Preparation Example 1

3-Glycidoxypropyltrimethoxysilane (23.6 g; 0.1 mol) was dissolved in ethanol, and an aqueous hydrochloric acid was added to the resulting solution while stirring it. After reacting the mixture at room temperature for 24 hours, the reaction was continued at 60°C for another 144 hours. After cooling it down to room temperature, ammonia was added to the reaction mixture and the reaction was continued further for 24 hours. After completion of the reaction, the reaction mixture was introduced into distilled water, and the resulting precipitates were filtered to obtain a white polymer. The product was soluble in various organic solvents such as tetrahydrofuran (THF), ethanol, ethylene glycol monoethyl ether (ethylcellosolve), methyl isobutyl ketone (MIBK), and acetone. From solutions of these solvents were obtained transparent uniform films.

### Preparation Example 2

3-Glycidoxypropyltrimethoxysilane (11.8 g; 0.05 mol) and phenyltriethoxysilane (12.0 g; 0.05 mol) were dissolved in ethanol, and an aqueous hydrochloric acid was added to the resulting solution while stirring it. After reacting the mixture at room temperature for 24 hours, the reaction was continued at 60°C for another 144 hours. After completion of the reaction, the reaction mixture was introduced into distilled water, and the resulting precipitate was filtered to obtain a white polymer. The product was soluble in various organic solvents such as THF, ethanol, ethylcello-solve, MIBK, acetone, and ethyl acetate. From solutions of these solvents were obtained transparent uniform films.

### Preparation Example 3

3-Glycidoxypropyltrimethoxysilane (11.8 g; 0.05 mol) and methyltriethoxysilane (8.9 g; 0.05 mol) were dissolved in ethanol, and an aqueous hydrochloric acid was added to the resulting solution while stirring it. After reacting the mixture at room temperature for 24 hours, the reaction was continued at 60°C for another 144 hours. After completion of the reaction, the reaction mixture was introduced into distilled water, and the resulting precipitate was filtered to obtain a white polymer. The product was soluble in various organic solvents such as THF, ethanol, ethylcello-solve, MIBX, acetone, and ethyl acetate. From solutions of these solvents were obtained transparent uniform films.

### Preparation Example 4

3-Glycidoxypropyltrimethoxysilane (4.72 g; 0.02 mol), methyltriethoxysilane (8.9 g; 0.05 mol), and tetraethoxysilane (6.24 g; 0.03 mol) were dissolved in ethanol, and an aqueous hydrochloric acid was added to the resulting solution while stirring it. After reacting the mixture at room temperature for 6 hours, ammonia was added to the reaction mixture and the reaction was continued at 60°C for further 24 hours. After completion of the reaction, the reaction mixture was introduced into distilled water, and the resulting precipitate was filtered to obtain a white polymer. The product was soluble in various organic solvents such as THF, ethanol, ethylcellosolve, MIBK, acetone, and ethyl acetate. From solutions of these solvents were obtained transparent uniform films.

### Preparation Example 5

2-(3,4-Epoxycyclohexyl)ethyltrimethoxysilane (24.6 g; 0.1 mol) was dissolved in ethanol, and an aqueous hydrochloric acid was added to the resulting solution while stirring it. After reacting the mixture at room temperature for 24 hours, the reaction was continued at 60°C for another 144 hours. After completion of the reaction, the reaction mixture was introduced into distilled water, and the resulting precipitate was filtered to obtain a white polymer. The product was soluble in various organic solvents such as THF, ethanol, ethylcellosolve, MIBK, and acetone. From solutions of these solvents were obtained transparent uniform films.

### Preparation Example 6

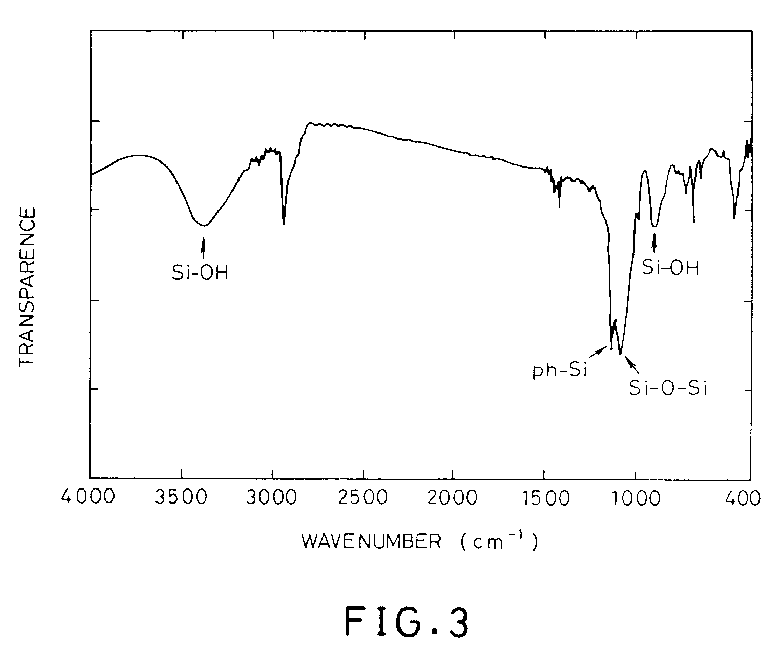

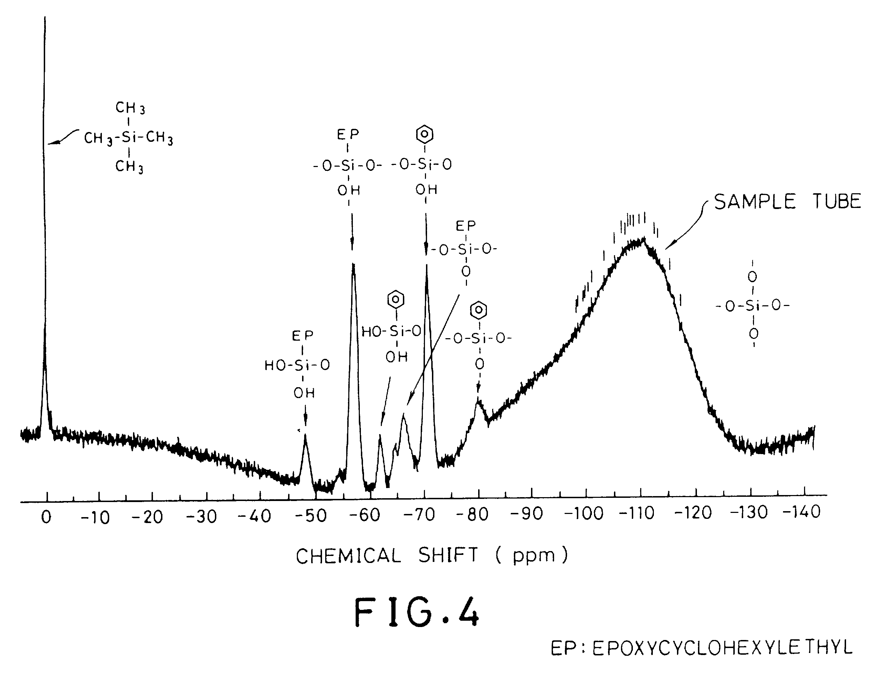

2-(3,4-Epoxycyclohexyl)ethyltrimethoxysilane (12.3 g; 0.05 mol) and phenyltriethoxysilane (13.6 g; 0.05 mol) were dissolved in ethanol, and an aqueous hydrochloric acid was added to the resulting solution while stirring it. After reacting the mixture at room temperature for 24 hours, the reaction was continued at 60°C for another 144 hours. After completion of the reaction, the reaction mixture was introduced into distilled water, and the resulting precipitate was filtered to obtain a white polymer. The product was soluble in various organic solvents such as THF, ethanol, ethylcellosolve, MIBK, and acetone. From solutions of these solvents were obtained transparent uniform films. The polymer was subjected to infrared absorption analysis, and nuclear magnetic resonance analysis using ²⁹Si. Fig. 3 is a chart illustrating an infrared absorption spectrum of the polymer. In Fig. 3, absorptions by OH groups in silanol are observed at 3,400 cm⁻¹ and 905 cm⁻¹. Fig. 4 is a ²⁹Si-NMR chart illustrating peaks of Si assigned to the following partial structural units represented by formulae (1A) to (6A), respectively, below; 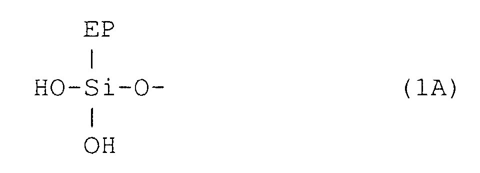 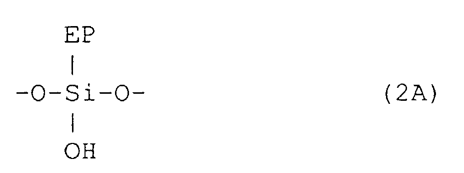 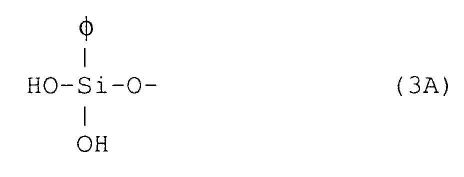 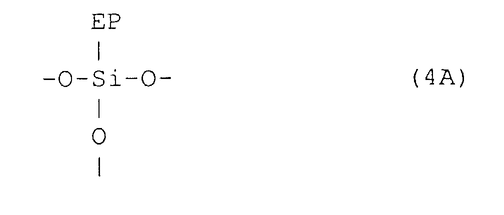 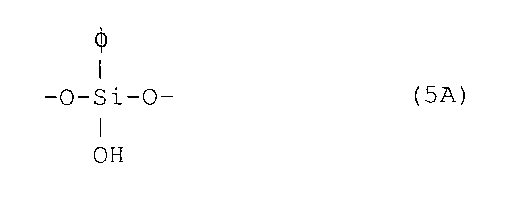 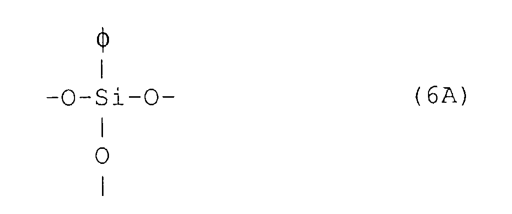 where EP represents an organic radical containing an epoxy group, and φ represents a phenyl group, at -48 ppm, -57 ppm, -62 ppm, -67 ppm, - 71 ppm, and -81 ppm, respectively. The polymer had a molecular weight of about 1,500.

### Preparation Example 7

2-(3,4-Epoxycyclohexyl)ethyltrimethoxysilane (12.3 g; 0.05 mol) and methyltriethoxysilane (8.9 g; 0.05 mol) were dissolved in ethanol, and an aqueous hydrochloric acid was added to the resulting solution while stirring it. After reacting the mixture at room temperature for 24 hours, the reaction was continued at 60°C for another 144 hours. After completion of the reaction, the reaction mixture was introduced into distilled water, and the resulting precipitate was filtered to obtain a white polymer. The product was soluble in various organic solvents such as THF, ethanol, ethylcellosolve, MIBK, acetone, and ethyl acetate. From solutions of these solvents were obtained transparent uniform films.

### Preparation Example 8

2-(3,4-Epoxycyclohexyl)ethyltrimethoxysilane (4.92 g; 0.02 mol), methyltriethoxysilane (8.9 g; 0.05 mol), and tetraethoxysilane (6.24 g; 0.03 mol) were dissolved in ethanol, and an aqueous hydrochloric acid was added to the resulting solution while stirring it. After reacting the mixture at room temperature for 6 hours, ammonia water was added to the reaction mixture, and the reaction was continued at 60°C for further 24 hours. After cooling it to room temperature, ammonia water was added to the reaction mixture, and the reaction was continued for additional 12 hours. After completion of the reaction, the reaction mixture was introduced into distilled water, and the resulting precipitate was filtered to obtain a white polymer. The product was soluble in various organic solvents such as THF, ethanol, ethylcellosolve, MIBK, acetone, and ethyl acetate. From solutions of these solvents were obtained transparent uniform films.

### Preparation Example 9

2-(3,4-Epoxycyclohexyl)ethyltrimethoxysilane (4.92 g; 0.02 mol) and phenyltriethoxysilane (19.2 g; 0.08 mol) were dissolved in ethanol, and an aqueous hydrochloric acid solution was added to the resulting solution while stirring it. After reacting the resulting mixture at room temperature for 24 hours, the reaction was continued at 60°C for another 144 hours. After completion of the reaction, the reaction mixture was introduced into distilled water, and the resulting precipitate was filtered to obtain a white polymer. The product was soluble in various organic solvents such as THF, ethanol, ethylcellosolve, MIBK, acetone, and ethyl acetate. From solutions of these solvents were obtained transparent uniform films.

### Preparation Example 10

2-(3,4-Epoxycyclohexyl)ethyltrimethoxysilane (2.46 g; 0.01 mol), 4-trimethoxysilyltetrahydrophthalic acid anhydride (2.72 g; 0.01 mol), and phenyltriethoxysilane (19.2 g; 0.08 mol) were dissolved in ethanol, and an aqueous hydrochloric acid solution was added to the resulting solution while stirring it. After reacting the resulting mixture at room temperature for 24 hours, the reaction was continued at 60°C for another 144 hours. After completion of the reaction, the reaction mixture was introduced into distilled water, and the resulting precipitate was filtered to obtain a white polymer. The product was soluble in various organic solvents such as THF, ethanol, ethylcellosolve, MIBK, acetone, and ethyl acetate. From solutions of these solvents were obtained transparent uniform films.

### Preparation Example 11

2-(3, 4-Epoxycyclohexyl)ethyltrimethoxysilane (4.92 g; 0.02 mol) and methyltriethoxysilane (14.2 g; 0.08 mol) were dissolved in ethanol, and an aqueous hydrochloric acid solution was added to the resulting solution while stirring it. After reacting the resulting mixture at room temperature for 24 hours, the reaction was continued at 60°C for another 144 hours. After completion of the reaction, the reaction mixture was introduced into distilled water, and the resulting precipitate was filtered to obtain a white polymer. The product was soluble in various organic solvents such as THF, ethanol, ethylcellosolve, MIBK, acetone, and ethyl acetate. From solutions of these solvents were obtained transparent uniform films.

### Example 1

The polysiloxanes obtained in Preparation Examples 1 to 11 were each mixed with 10 % by weight of 2,6-dinitrobenzyl tosylate to prepare resist compositions. The respective resist compositions were coated on a silicon wafer in a thickness of about 0.3 µm by a conventional spin coating method, and prebaked at 100°C for 20 minutes. After the prebaking, each coated substrate was imagewise irradiated with a high energy radiation (electron beams, X rays, deep ultraviolet rays). On this occasion, in the case of deep UV rays, peak wavelength was set up to 257 nm (cold mirror CM-250). After the imagewise irradiation, the coated substrates were each heated on a hot plate at 80°C for 5 minutes to effect postbaking (PEB), followed by development with a developer composed of HPRD 402 (trade name for an aqueous alkali solution containing about 3 % by weight of tetramethylammonium hydroxide (TMAH), manufactured by Fuji Hunt Co., hereafter the same) and water in a blend ratio of 1 : 1. D₅₀, the amount of radiation irradiated with which the thickness of the film remaining after the irradiation was 50 % of the initial thickness of the film prior to the irradiation, was defined as sensitivity of the resist.

Table 1 shows the sensitivity and resolution of each resist composition. Resolution was evaluated by forming line & space patterns. Each of the resist materials enabled the formation of patterns at a width of no larger than 0.3 µm.

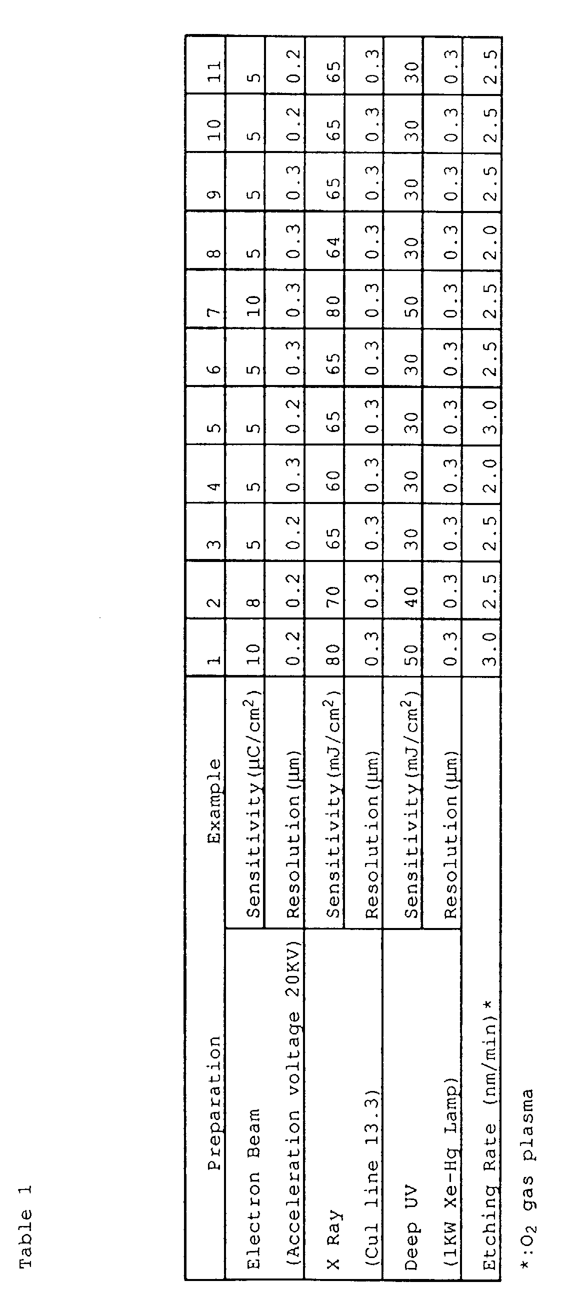

### Example 2

Respective resist compositions composed of one of the compositions of Example 1 and 0.5 % by weight based on polymer of phenathiazine as a spectral sensitizer were coated on a silicon wafer to a thickness of about 0.3 µm, and prebaked at 100°C for 20 minutes. After the prebaking, the coated substrates were each irradiated with ultraviolet rays using a Mask Aligner (manufactured by Canon Corporation). After the UV irradiation, the coated substrates were each subjected to the same heat treatment (PEB) as in Example 1, and then developed with the same developer as used in Example 1. D₅₀ was obtained for each of the resist materials as its sensitivity.

Table 2 shows the sensitivity and resolution of each resist composition. Resolution was evaluated by forming line & space patterns. All the resist compositions enabled the formation of patterns at a width of 0.5 µm.

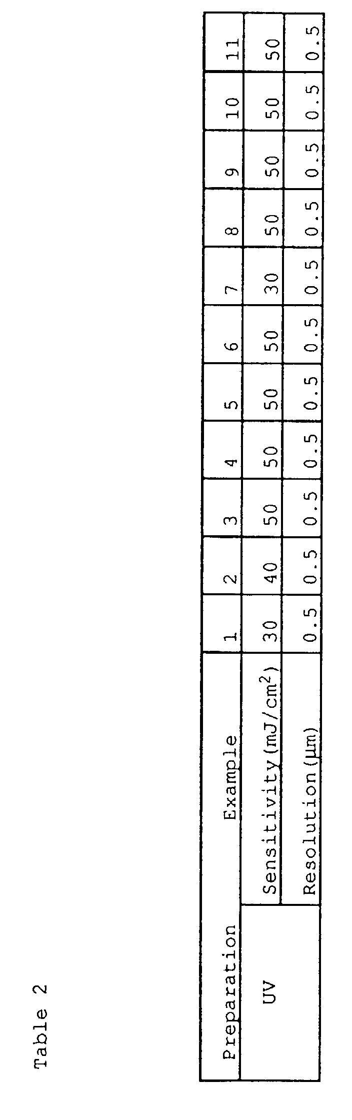

### Example 3

To the polysiloxane obtained in Preparation Example 3 was added one of the acid generators described below to prepare resist compositions, whose resist characteristics were evaluated in the same manner as in Example 1.

| | |
|---|---|
| Acid generator 1: | |
| Triphenylsulfonium hexafluoroantimonate | 2 % by weight |
| | |
| Acid generator 2: | |
| Triphenylsulfonium hexafluoroarsenate | 2 % by weight |
| | |
| Acid generator 3: | |
| Diphenyliodonium hexafluoroantimonate | 2 % by weight |
| | |
| Acid generator 4: | |
| Bis(t-butylphenyl)iodonium trifluoromethanesulfonate | 2 % by weight |
| | |
| Acid generator 5: | |
| 2,4-Bis(trichloromethyl)-6-phenyl-1,3,5-triazine | 10 % by weight |
| | |
| Acid generator 6: | |
| Iron allene hexafluorophosphate complex | 5 % by weight |
| | |
| Acid generator 7: | |
| Tris(2,3-dibromopropyl)isocyanurate | 5 % by weight |
| | |
| Acid generator 8: | |
| 4-Methoxybenzenediazonium trifluoromethanesulfonate | 5 % by weight |
| | |
| Acid generator 9: | |
| 2,4,6-Tris(trichloromethyl)-1,3,5-triazine | 5 % by weight |
| | |
| Acid generator 10: | |
| Tetrabromobisphenol A | 10 % by weight |
| | |
| Acid generator 11: | |
| Dibromomethyltriazine | 5 % by weight |

The results obtained are shown in Table 3.

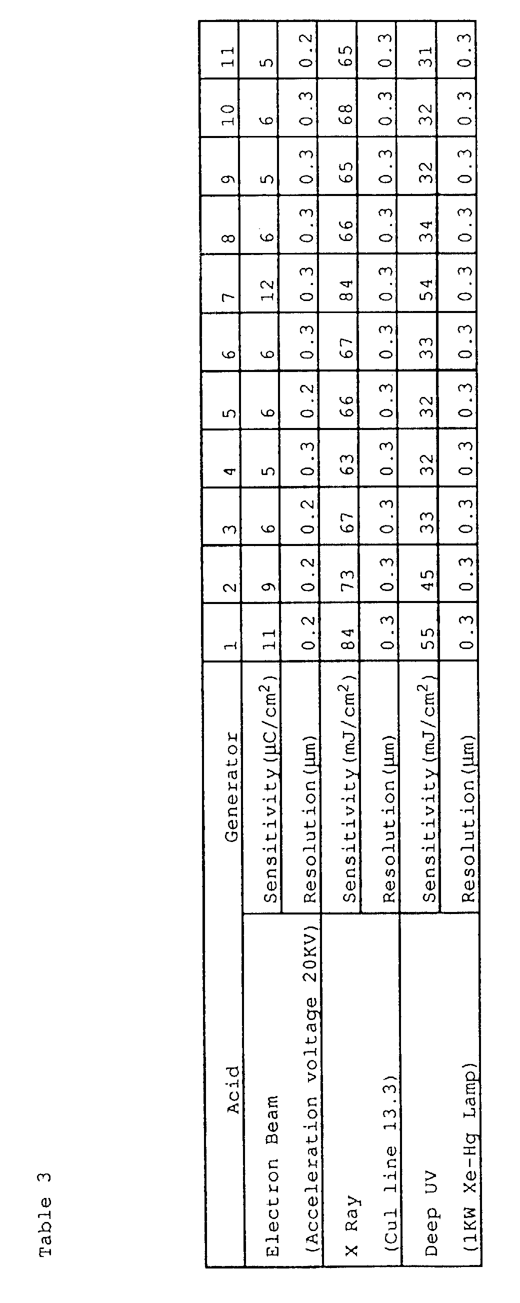

### Example 4

The polysiloxanes obtained in Preparation Examples 1 to 11 were each mixed with 10 % by weight of novolak resin and 10 % by weight of 2,6-dinitrobenzyl tosylate to prepare resist compositions. Each of the resist compositions was coated on a silicon wafer to a thickness of about 0.3 µm by a conventional spin coating method, and prebaked at 100°C for 20 minutes. After the prebaking, each coated substrate was imagewise irradiated with a high energy radiation (electron beams, X rays, deep ultraviolet rays). On this occasion, in the case of deep UV rays, peak wavelength was set up to 257 nm (cold mirror CM-250). After the imagewise irradiation, the coated substrates were each heated on a hot plate at 80°C for 5 minutes to effect postbaking (PEB), followed by development with a developer composed of HPRD 402 (manufactured by Fuji Hunt Co.) and water in a blend ratio of 1 : 1. D₅₀, the amount of radiation irradiated with which the thickness of the film remaining after the irradiation was 50 % of the initial thickness of the film prior to the irradiation, was defined as sensitivity of the resist.

Table 4 shows the sensitivity and resolution of each resist composition. Resolution was evaluated by forming line & space patterns. Each of the resist materials enabled the formation of patterns at a width of no larger than 0.3 µm.

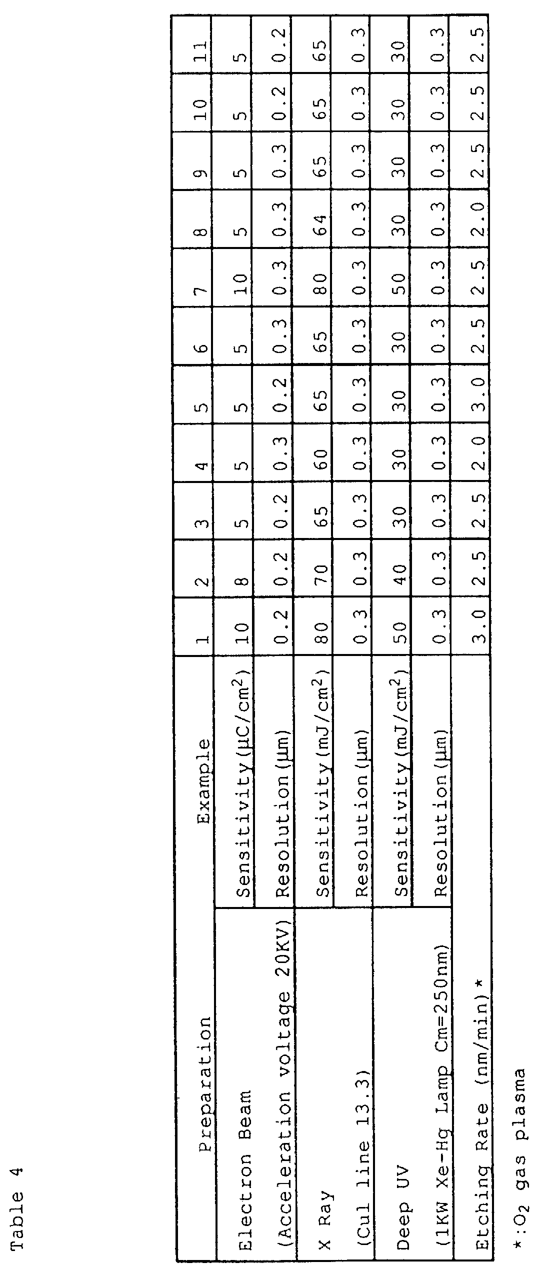

### Example 5

Resist compositions composed of one of the resist compositions of Example 4 and 0.5 % by weight based on polymer of phenathiazine as a spectral sensitizer were each coated on a silicon wafer to a thickness of about 0.3 µm, and prebaked at 100°C for 20 minutes. After the prebaking, the coated substrates were each irradiated with ultraviolet rays using a Mask Aligner (manufactured by Canon Corporation). After the UV irradiation, the coated substrates were each subjected to the same heat treatment (PEB) as in Example 1, and then developed with the same developer as used in Example 1. D₅₀ was obtained for each of the resist materials as its sensitivity.

Table 5 shows the sensitivity and resolution of each resist composition. Resolution was evaluated by forming line & space patterns. Each of the resist compositions enabled the formation of patterns at a width of 0.5 µm.

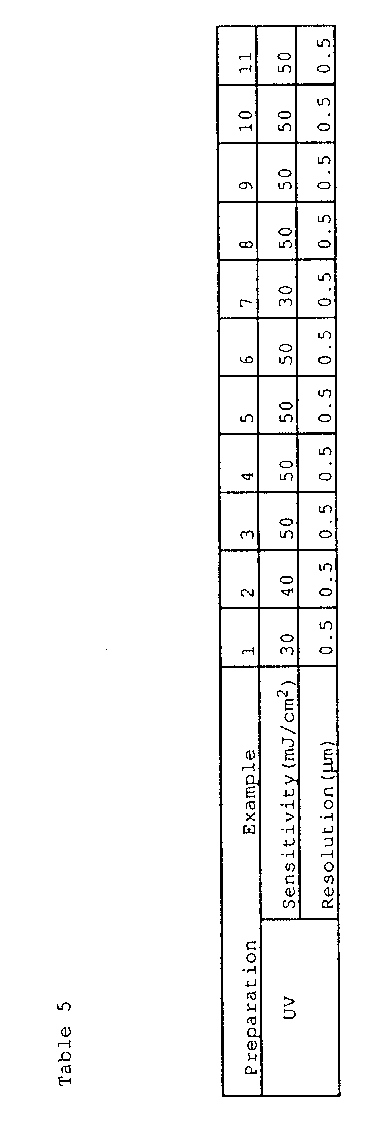

### Example 6

To the polysiloxane obtained in Preparation Example 3 were added 10 % by weight of novolak resin and one of the acid generators described below to prepare resist compositions, whose resist characteristics were evaluated in the same manner as in Example 1.

| | |
|---|---|
| Acid generator 1: | |
| Triphenylsulfonium hexafluoroantimonate | 2 % by weight |
| | |
| Acid generator 2: | |
| Triphenylsulfonium hexafluoroarsenate | 2 % by weight |
| | |
| Acid generator 3: | |
| Diphenyliodonium hexafluoroantimonate | 2 % by weight |
| | |
| Acid generator 4: | |
| Bis(t-butylphenyl)iodonium trifluoromethanesulfonate | 2 % by weight |
| | |
| Acid generator 5: | |
| 2,4-Bis(trichloromethyl)-6-phenyl-1,3,5-triazine | 10 % by weight |
| | |
| Acid generator 6: | |
| Iron allene hexafluorophosphate complex | 5 % by weight |
| | |
| Acid generator 7: | |
| Tris(2,3-dibromopropyl)isocyanurate | 5 % by weight |
| | |
| Acid generator 8: | |
| 4-Methoxybenzenediazonium trifluoromethanesulfonate | 5 % by weight |
| Acid generator 9: | |
| 2,4,6-Tris(trichloromethyl)-1,3,5-triazine | 5 % by weight |
| | |
| Acid generator 10: | |
| Tetrabromobisphenol A | 10 % by weight |
| | |
| Acid generator 11: | |
| Dibromomethyltriazine | 5 % by weight |

The results obtained are shown in Table 6.

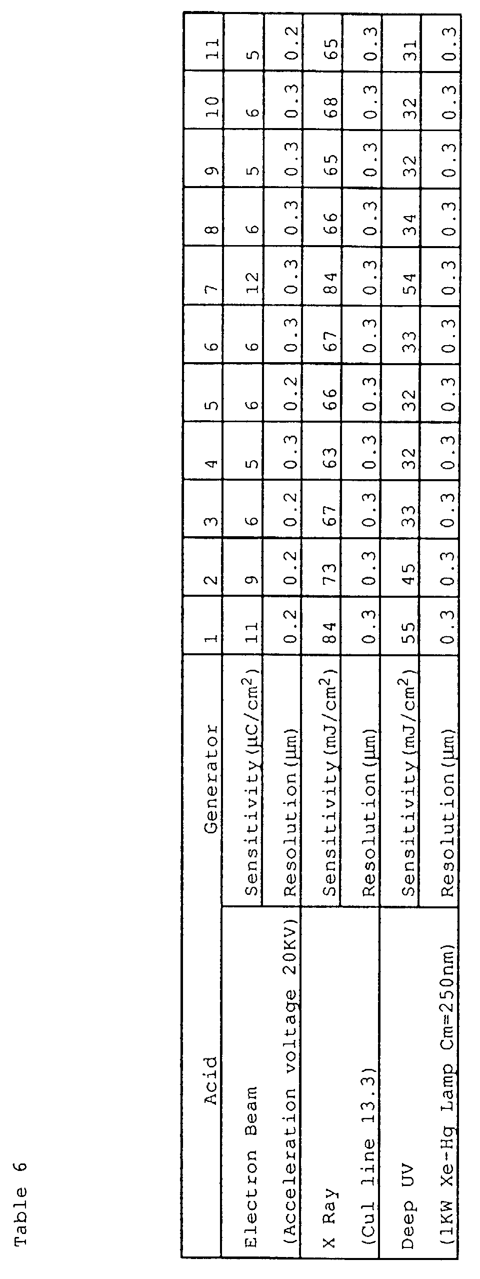

### Example 7

To the polysiloxane obtained in Preparation Example 1 was added 3 % by weight of triphenylsulfonium trifluoromethanesulfonate and 10 % by weight of one of the organic polymers having a hydroxyl group shown in Table 7 to prepare resist compositions. The resist characteristics of the resist compositions were evaluated in the same manner as in Example 1. The results obtained are shown in Table 7.

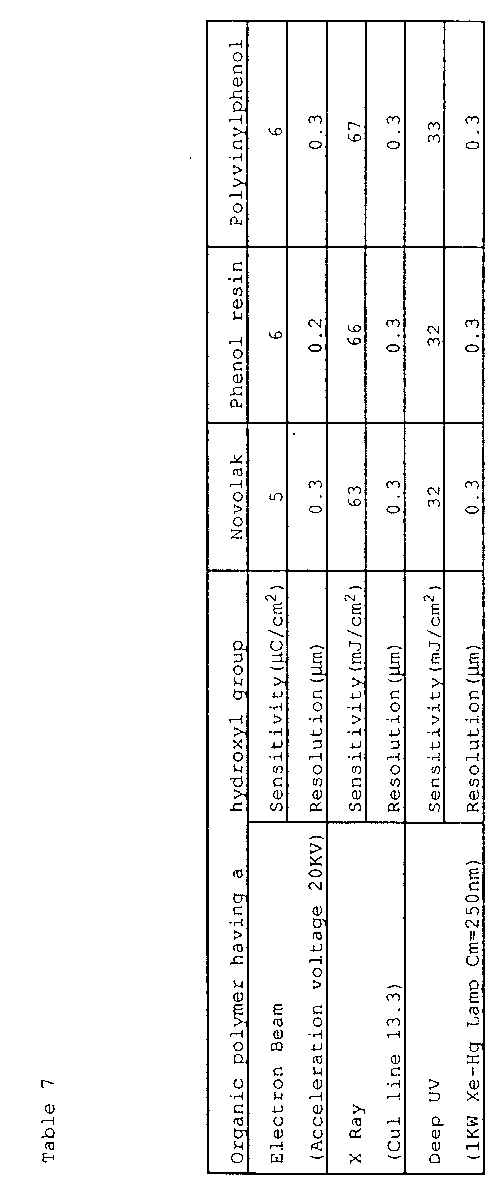

### Example 8

Silicon wafers were each coated with AZ-1350 resist (produced by Hoechst AG) to a thickness of 3 µm, and heated at 200°C for 30 minutes to insolubilize. The respective resist compositions used in Examples 1 to 6 were coated on the AZ-1350 resists each to a thickness of about 0.3 µm, and prebaked at 100°C for 20 minutes. After the prebaking, high energy radiation (electron beams, X rays, deep UV rays, or UV rays) was irradiated on each of the coated substrates. Then, the substrates thus treated were heated in the same manner as in Example 1, and developed with a developer having the same composition as that used in Example 1 to form patterns. Thereafter, the AZ resists were etched in a parallel flat plate type sputter etching apparatus using oxygen gas as an etching gas and one of the aforementioned resist patterns as a mask. After etching performed under the conditions of RF power: 0.2 W/cm², and O₂ gas pressure: 20 mTorr, for 15 minutes, the AZ resist in the portion uncovered with the resist pattern disappeared completely.

All the resist compositions used in Example 1 gave rise to 0.3 µm line & space patterns each in a thickness of about 3 µm while the use of the resist compositions in Example 2 enabled the formation of 0.5 µm line & space patterns.

### Example 9

A mixture of one of the polysiloxanes obtained in Preparation Examples 1 to 11, 10 % by weight of polyvinylphenol, and 3 % by weight of diphenyl-4-thiophenoxyphenylsulfonium hexafluorophosphate was dissolved in methoxy-2-propanol to prepare resist compositions. Each of the resist compositions was coated on a silicon wafer to a thickness of about 0.3 µm by a conventional spin coating method, and prebaked at 100°C for 20 minutes. After the prebaking, each coated substrate was imagewise irradiated with a high energy radiation (electron beams, X rays, or deep ultraviolet rays). On this occasion, in the case of deep UV rays, peak wavelength was set up to 257 nm (cold mirror CM-250). After the imagewise irradiation, the coated substrates were each heated on a hot plate at 80°C for 5 minutes to effect postbaking (PEB), followed by development with a developer composed of HPRD 402 (manufactured by Fuji Hunt Co.) and water in a blend ratio of 1 : 1. D₅₀, the amount of radiation irradiated with which the thickness of the film remaining after the irradiation was 50 % of the initial thickness of the film prior to the irradiation, was defined as sensitivity of the resist.

Table 8 shows the sensitivity and resolution of each resist composition. Resolution was evaluated by forming line & space patterns. Each of the resist compositions enabled the formation of patterns at a width of no larger than 0.25 µm.

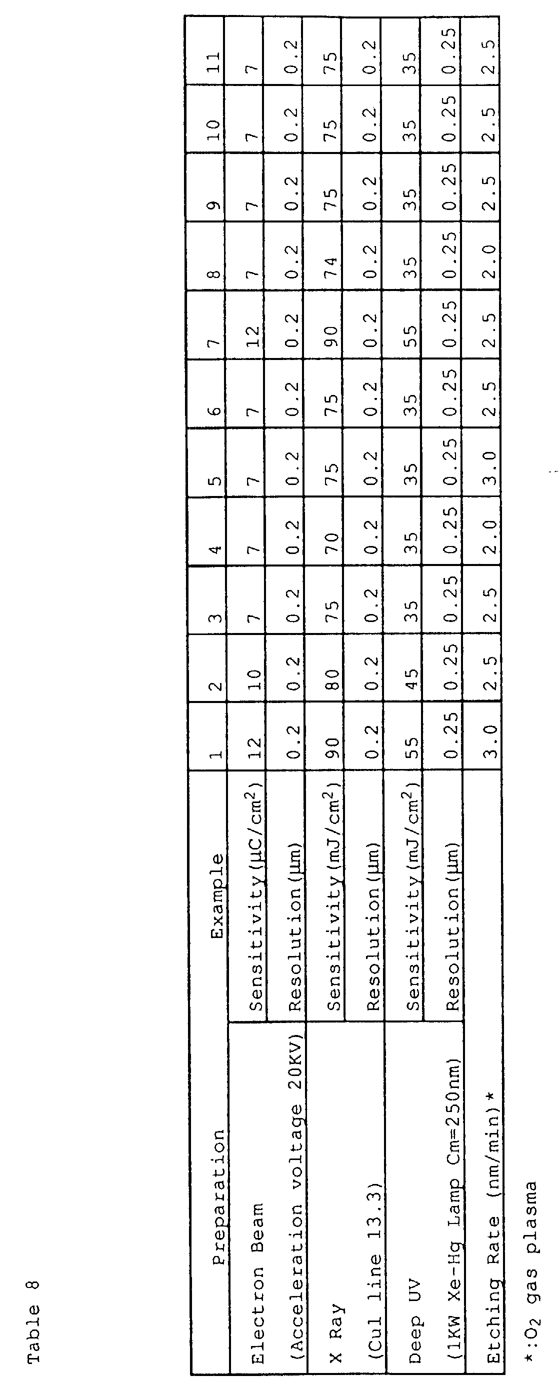

### Example 10

Resist compositions composed of one of the resist compositions of Example 9 and 0.5 % by weight based on polymer of phenathiazine as a spectral sensitizer were each coated on a silicon wafer to a thickness of about 0.3 µm, and prebaked at 100°C for 20 minutes. After the prebaking, the coated substrates were each irradiated with UV rays using an i-line stepper (manufactured by Nikon). After the UV irradiation, the coated substrates were each subjected to the same heat treatment (PEB) as in Example 9, and then developed with the same developer as used in Example 9. D₅₀ was obtained for each of the resist materials as its sensitivity.

Table 9 shows the sensitivity and resolution of each resist composition. Resolution was evaluated by forming line & space patterns. All the resist compositions enabled the formation of patterns at a width of 0.35 µm.

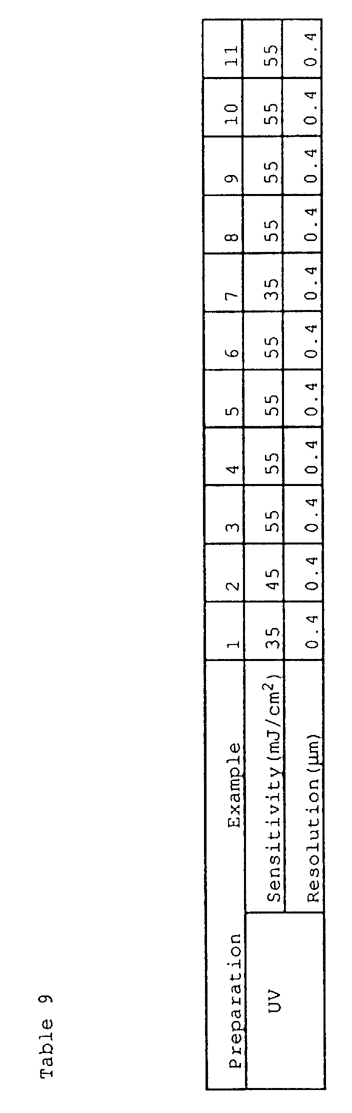

### Example 11

To the polysiloxane obtained in Preparation Example 6 were added 10 % by weight of polyvinylphenol, and one of the acid generators described below to prepare resist compositions, whose resist characteristics were evaluated in the same manner as in Example 9.

| | |
|---|---|
| Acid generator 1: | |
| Triphenylsulfonium hexafluoroantimonate | 2 % by weight |
| | |
| Acid generator 2: | |
| Triphenylsulfonium hexafluoroarsenate | 2 % by weight |
| | |
| Acid generator 3: | |
| Diphenyliodonium hexafluoroantimonate | 2 % by weight |
| | |
| Acid generator 4: | |
| Bis(t-butylphenyl)iodonium trifluoromethanesulfonate | 2 % by weight |
| | |
| Acid generator 5: | |
| 2,4-Bis(trichloromethyl)-6-phenyl-1,3,5-triazine | 10 % by weight |
| | |
| Acid generator 6: | |
| Iron allene hexafluorophosphate complex | 5 % by weight |
| | |
| Acid generator 7: | |
| Tris(2,3-dibromopropyl)isocyanurate | 5 % by weight |
| | |
| Acid generator 8: | |
| 4-Methoxybenzenediazonium trifluoromethanesulfonate | 5 % by weight |
| Acid generator 9: | |
| 2,4,6-Tris(trichloromethyl)-1,3,5-triazine | 5 % by weight |
| | |
| Acid generator 10 | |
| Tetrabromobisphenol A | 10 % by weight |
| | |
| Acid generator 11: | |
| Dibromomethyltriazine | 5 % by weight |
| | |
| Acid generator 12: | |
| 2,6-Dinitrobenzyl tosylate | 10 % by weight |

The results obtained are shown in Table 10.

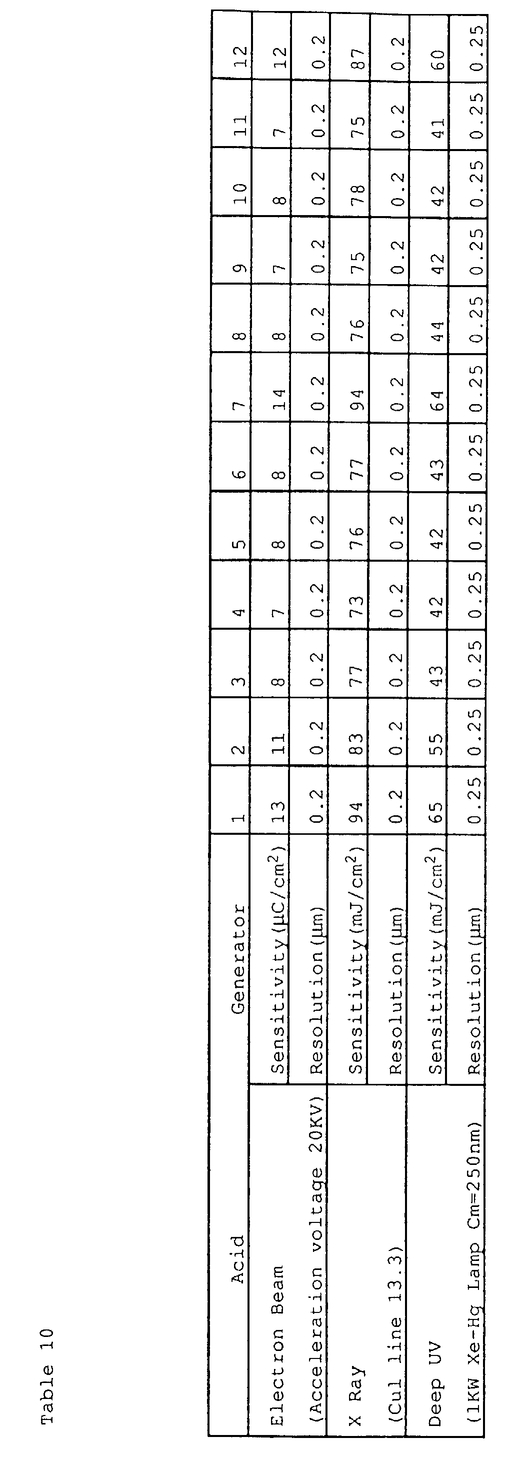

### Example 12

Silicon wafers were each coated with AZ-1350 resist (produced by Hoechst AG) to a thickness of 3 µm, and heated at 200°C for 30 minutes to insolubilize. The respective resist compositions used in Examples 9, 10 or 11 were coated on the AZ-1350 resists each to a thickness of about 0.3 µm, and prebaked at 100°C for 20 minutes. After the prebaking, high energy radiation (electron beams, X rays, deep UV rays, or UV rays) was irradiated on each of the coated substrates. Then, the substrates thus treated were heated in the same manner as in Examples 9 or 10, and developed with a developer having the same composition as that used in Example 9 to form patterns. Thereafter, the AZ resists were etched in a parallel flat plate type sputter etching apparatus using oxygen gas as an etching gas and one of the aforementioned resist patterns as a mask. After etching performed under the conditions of RF power: 0.2 W/cm², and O₂ gas pressure: 20 mTorr, for 15 minutes, the AZ resist in the portion uncovered with the resist pattern disappeared completely.

All the resist compositions used in Example 9 gave rise to at most 0.25 µm line & space patterns each in a thickness of about 3 µm while the use of the resist compositions in Example 10 enabled the formation of 0.35 m line & space patterns.

### Example 13

To the polysiloxane obtained in Preparation Example 6 was added 3 % by weight of diphenyl-4-thiophenoxyphenylsulfonium hexafluorophosphate and 10 % by weight of one of the organic polymers having a hydroxyl group shown in Table 11 to prepare resist compositions. The resist characteristics of the resist compositions were evaluated in the same manner as in Example 9. The results obtained are shown in Table 11.

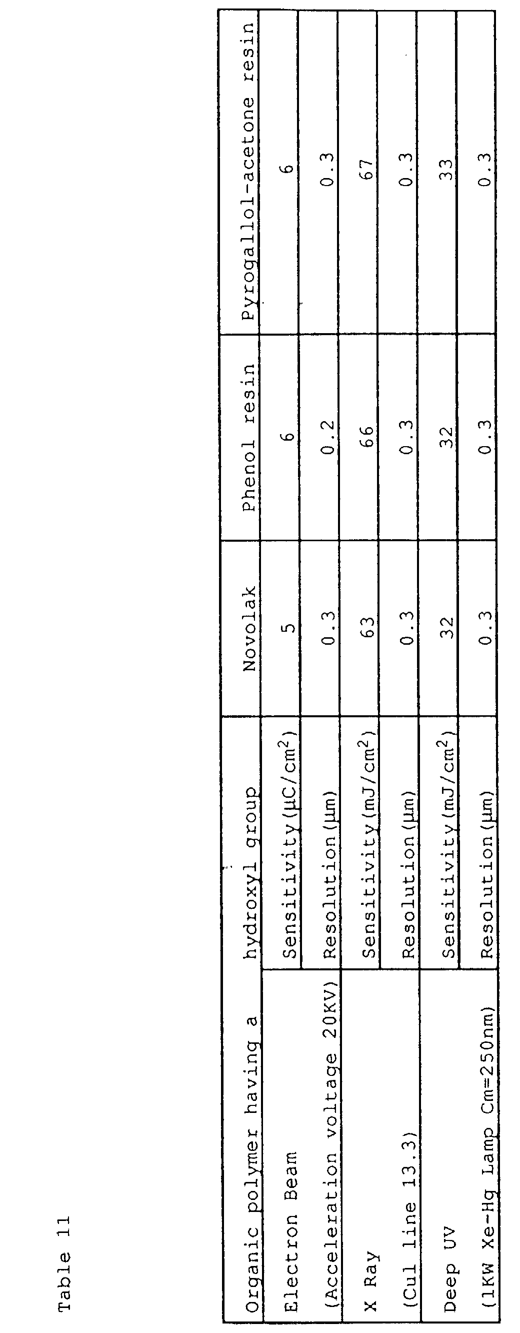

### Example 14

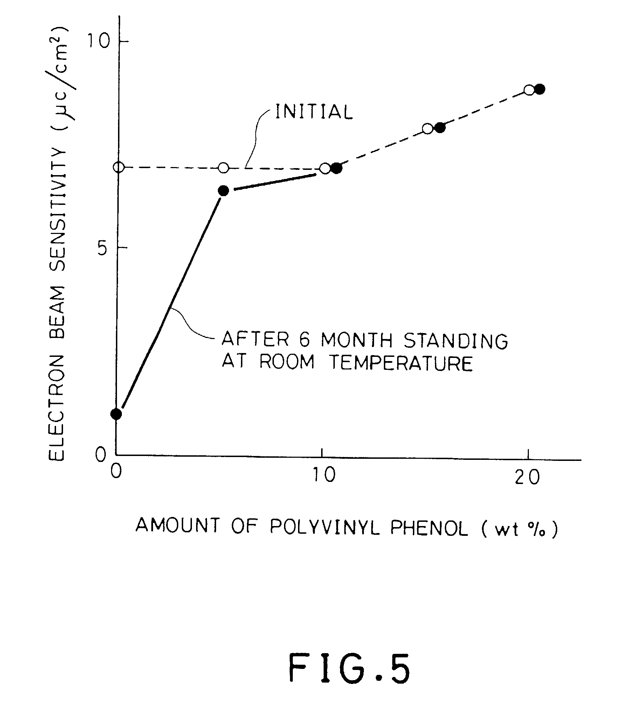

To the polysiloxane obtained in Preparation Example 6 were added 3 % by weight of diphenyl-4-thiophenoxyphenylsulfonium hexafluorophosphate and a certain amount of polyvinylphenol to obtain resist compositions. The sensitivities thereof were evaluated after having left the resist compositions to stand at room temperature for 6 months. Fig. 5 shows the relationship between the amount of the polyvinylphenol and sensitivity. As will be understood from Fig. 5, the addition of polyvinylphenol resin resulted in a slight decrease in the sensitivity but in considerable improvement in the stability with time. In other words, resist compositions with no polyvinylphenol showed a larger change in the sensitivity after standing at room temperature for 6 months as compared with the resist compositions to which the polyvinylphenol was added.

### Example 15

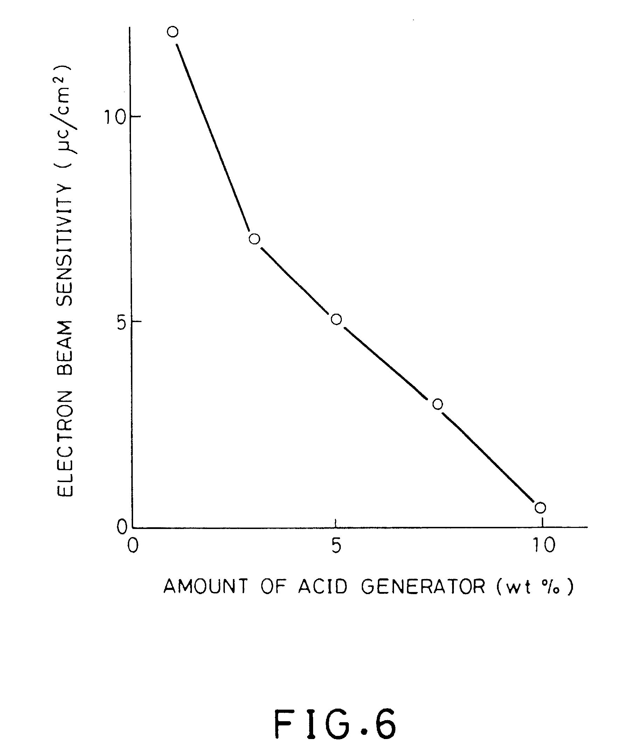

To the polysiloxane obtained in Preparation Example 6 were added a certain amount of diphenyl-4-thiophenoxyphenyl-sulfonium hexafluorophosphate and 10 % by weight of polyvinylphenol to obtain resist compositions. The sensitivities thereof were evaluated after having left the resist compositions to stand at room temperature for 6 months. Fig. 6 shows the relationship between the amount of the diphenyl-4-thiophenoxyphenylsulfonium hexafluorophosphate added and sensitivity. As will be understood from Fig. 6, the larger the amount the higher the sensitivity but the lower the storage stability.

### Example 16

To the polysiloxane obtained in Preparation Example 6 were added 3 % by weight of triphenylphosphonium trifluoromethanesulfonate and 5 % by weight of one of the epoxy compounds shown in Table 12 to obtain resist compositions. The resist characteristics of the resist compositions were evaluated in the same manner as in Example 9. The results obtained are shown in Table 12.

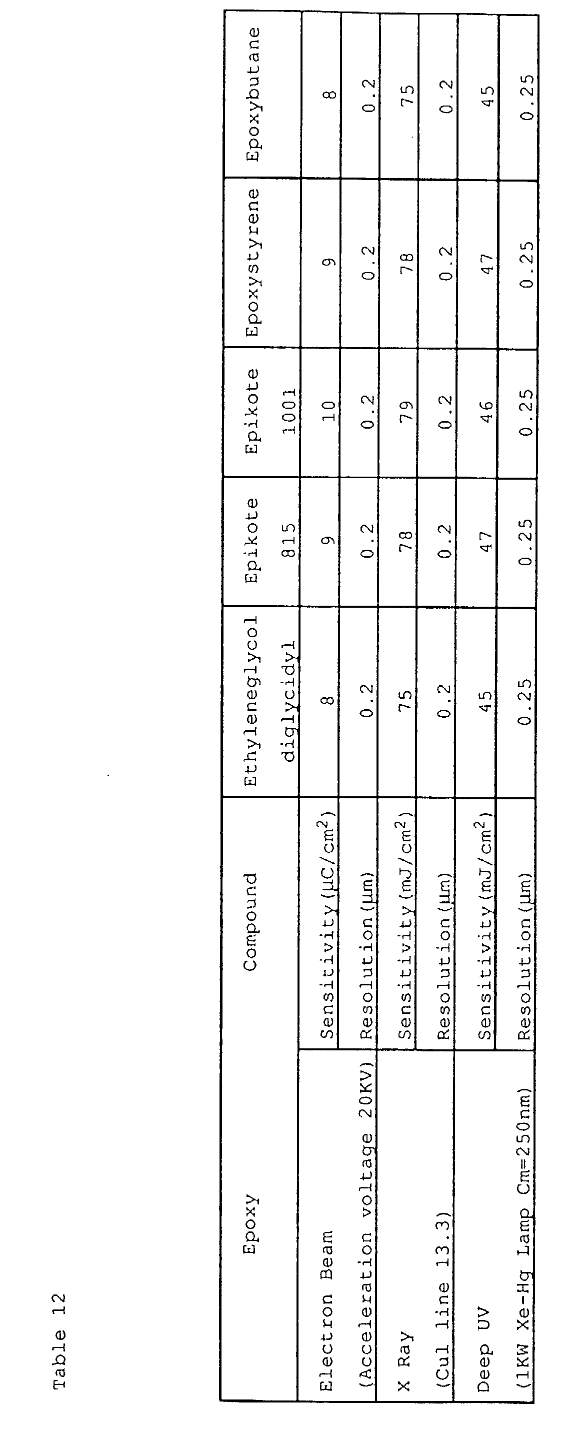

The present invention has been described in detail with respect to preferred embodiments, and it will now be apparent from the foregoing to those skilled in the art that changes and modifications may be made without departing from the invention in its broader aspects, and it is the invention, therefore, in the appended claims to cover all such changes and modifications as fall within the true spirit of the invention.

A resist material comprises a polysiloxane obtained by hydrolysis and condensation with dehydration of one or more alkoxysilanes having an oxirane ring, or of a mixture of the alkoxysilane(s) having an oxirane ring and one or more alkoxysilanes having no oxirane ring, and an acid generator. The resist material may contain one or more of a spectral sensitizer, an organic polymer having a hydroxyl group or an epoxy compound. Resist patterns are formed by coating an organic polymer on a substrate (1) and then the resist material on the film of the organic polymer to form a two layer resist having a bottom layer (2) of the organic polymer and top layer (3) of the resist material, prebaking, imagewise exposing high radiation, postbaking, and developing the resist with alkaline solutions to remove an unexposed portion of the top layer, and dry etching the bottom layer using the relic of the resist material as a mask. The temperature of the post baking is preferably lower than that of the prebaking.

## Claims

1. A resist material characterized by comprising:
(a) a polysiloxane comprising hydroxyl groups in the polymer having partial structural units represented by formulae (1) to (3), respectively, below; and 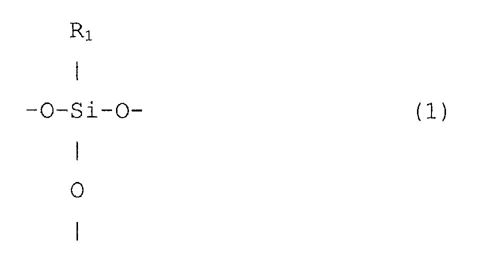 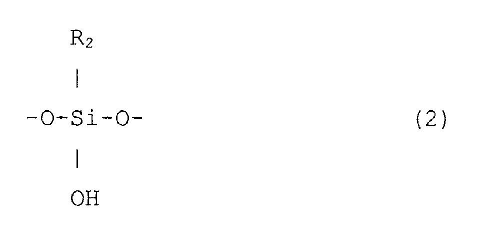 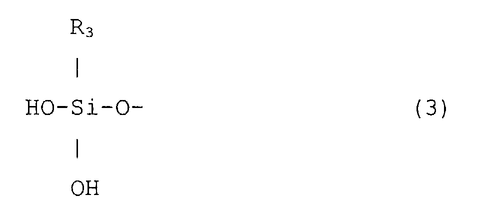 wherein R₁, R₂, and R₃, which are the same or different, each represent an organic group, a part or all of a plurality of groups represented by R₁, R₂, and R₃, respectively, have an oxirane ring, and said partial structural units represented by formulae (1), (2) and (3), respectively, are connected to each other so as to complete siloxane bonds; and
(b) an acid generator.

2. A resist material as claimed in claim 1, characterized in that said R₁, R₂ and R₃, which are the same or different, each represent an alkyl group, an alkenyl group, a cycloalkyl group, a phenyl group, or a 4-tetrahydro-phthalic anhydride group.

3. A resist material as claimed in claim 2, characterized in that said R₁, R₂ and R₃, which are the same or different, each represent a 3-glycidoxypropyl group, a 2-(3,4-epoxycyclohexyl)ethyl group, an ethyl group, a methyl group, a phenyl group, or a 4-tetrahydro-phthalic anhydride group.

4. A resist material as claimed in claim 3, characterized in that R₁, R₂ and R₃, which may be the same or different, each represent 2-(3,4-epoxycyclohexyl)ethyl group or a phenyl group.

5. A resist material as claimed in any one of preceding claims 1 to 4, characterized in that abundance of said groups represented by said R₁, R₂ and R₃ and having an oxirane ring is 20 to 100% by mole based on total groups represented by said R₁, R₂ and R₃.

6. A resist material as claimed in any one of preceding claims 1 to 5, characterized in that said polysiloxane has a weight average molecular weight of 800 to 10,000.

7. A resist material as claimed in any one of preceding claims 1 to 6, characterized in that said acid generator is one selected from the class consisting of:
(i) an onium salt represented by formula (I), (II) or (III) below;
R'N₂⁺MXₙ⁻ (I)
(R')₂I⁺MXₙ⁻ (II)
(R')₃S⁺MXₙ⁻ (III)
wherein R' represents an unsubstituted or substituted aromatic group, and MXₙ⁻ represents a group selected from the group consisting of BF₄⁻, PF₆⁻, AsF₆⁻, and SbF₆⁻,
(ii) a halomethyltriazine,
(iii) tetrabromobisphenol A,
(iv) a nitrobenzyl ester compound, and
(v) a trifluoromethanesulfonate compound.

8. A resist material as claimed in claim 7, characterized in that said acid generator is diphenyl-4-thiophenoxyphenylsulfonium hexafluorophosphate.

9. A resist material as claimed in any one of preceding claims 1 to 8, characterized by further comprising a spectral sensitizer.

10. A resist material as claimed in any one of preceding claims 1 to 9, characterized by further comprising an organic polymer having a hydroxyl group.

11. A resist material as claimed in any one of preceding claims 1 to 10, characterized by further comprising an epoxy compound.

12. A resist material according to any one of claims 1 to 11, wherein said polysiloxane comprises an alkoxysilane having an oxirane ring alone, and optionally a polysiloxane free of an oxirane ring.

13. A resist material according to any one of claims 1 to 12, wherein said resist material is a negative working resist material.

14. A method of producing a resist material according to any one of claims 1 to 13, characterized by comprising the steps of:
hydrolyzing an alkoxysilane having an oxirane ring to form a hydrolyzate;
condensing with dehydration said hydrolyzate to form a polysiloxane; and
mixing said polysiloxane with an acid generator.

15. A method of producing a resist material according to any one of claims 1 to 13, characterized by comprising the steps of:
hydrolyzing an alkoxysilane having an oxirane ring and an alkoxysilane free of an oxirane ring to form a hydrolyzate;
condensing with dehydration said hydrolyzate to form a polysiloxane; and
mixing said polysiloxane with an acid generator.

16. A process of forming resist patterns, characterized by comprising the steps of:
applying an organic polymer on a substrate to form a bottom layer on a substrate;
coating a resist material as claimed in any one of preceding claims 1 to 13 on said bottom layer to form a top layer, thus forming a two layer resist on said substrate;
prebaking said two layer resist;
imagewise exposing said prebaked two layer resist with high energy radiation to obtain an exposed two layer resist having an exposed portion of said top layer and an unexposed portion of said top layer;
post-baking said exposed two layer resist to render said exposed portion of said top layer insoluble in an alkali developer;
developing said exposed two layer resist with an alkali developer to remove said unexposed portion of said top layer while retaining said insolubilized, exposed portion of said top layer on said bottom layer to form space corresponding to said unexposed portion of said top layer; and
dry etching said bottom layer using said remaining exposed portion of said top layer as a mask to remove said bottom layer in a region beneath said space corresponding to said unexposed portion of said top layer.

17. A process as claimed in claim 16, characterized in that said post-baking is performed at a temperature lower than that at which said prebaking is carried out.

## Patentansprüche

1. Resistmaterial, dadurch gekennzeichnet, daß es
(a) ein Polysiloxan, das in dem Polymer mit Teilstruktureinheiten, die jeweils durch die nachstehenden Formeln (1) bis (3) wiedergegeben werden, Hydroxylgruppen hat: 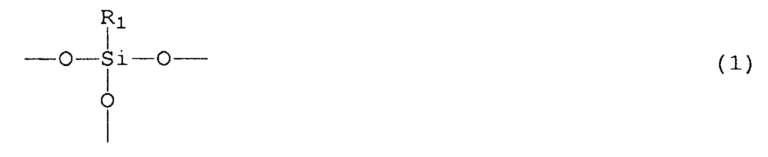 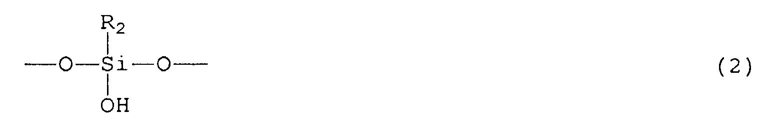 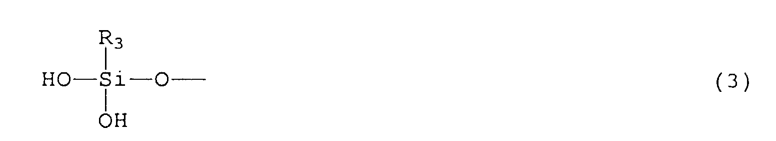 worin R₁, R₂ und R₃, die gleich oder verschieden sind, jeweils eine organische Gruppe wiedergeben, wobei ein Teil oder alle einer Vielzahl von Gruppen, die durch R₁, R₂ bzw. R₃ wiedergeben werden, einen oxiranring haben und die erwähnten Teilstruktureinheiten, die durch die Formeln (1), (2) bzw. (3) wiedergegeben werden, derart miteinander verbunden sind, daß Siloxanbindungen vervollständigt werden; und
(b) einen Säurebildner umfaßt.

2. Resistmaterial nach Anspruch 1, dadurch gekennzeichnet, daß die erwähnten R₁, R₂ und R₃, die gleich oder verschieden sind, jeweils eine Alkylgruppe, eine Alkenylgruppe, eine Cycloalkylgruppe, eine Phenylgruppe oder eine 4-Tetrahydrophthalsäureanhydridgruppe wiedergeben.

3. Resistmaterial nach Anspruch 2, dadurch gekennzeichnet, daß die erwähnten R₁, R₂ und R₃, die gleich oder verschieden sind, jeweils eine 3-Glycidoxypropylgruppe, eine 2-(3,4-Epoxycyclohexyl)-ethylgruppe, eine Ethylgruppe, eine Methylgruppe, eine Phenylgruppe oder eine 4-Tetrahydrophthalsäureanhydridgruppe wiedergeben.

4. Resistmaterial nach Anspruch 3, dadurch gekennzeichnet, daß R₁, R₂ und R₃, die gleich oder verschieden sein können, jeweils eine 2-(3,4-Epoxycyclohexyl)-ethylgruppe oder eine Phenylgruppe wiedergeben.

5. Resistmaterial nach einem der vorhergehenden Ansprüche 1 bis 4, dadurch gekennzeichnet, daß die Häufigkeit der erwähnten Gruppen, die durch die erwähnten R₁, R₂ und R₃ wiedergegeben werden und einen Oxiranring haben, 20 bis 100 Mol%, auf die gesamten Gruppen, die durch die erwähnten R₁, R₂ und R₃ wiedergegeben werden, bezogen, beträgt.

6. Resistmaterial nach einem der vorhergehenden Ansprüche 1 bis 5, dadurch gekennzeichnet, daß das erwähnte Polysiloxan eine massegemittelte Molmasse von 800 bis 10.000 hat.

7. Resistmaterial nach einem der vorhergehenden Ansprüche 1 bis 6, dadurch gekennzeichnet, daß der erwähnte Säurebildner einer ist, der aus der Gruppe ausgewählt ist, die aus
(i) einem Oniumsalz, das durch die nachstehende Formel (I), (II) oder (III) wiedergegeben wird:
R'N₂⁺MXₙ⁻ (I)
(R')₂I⁺MXₙ⁻ (II)
(R')₃S⁺MXₙ⁻ (III)
worin R' eine unsubstituierte oder substituierte aromatische Gruppe wiedergibt und MXₙ⁻ eine Gruppe wiedergibt, die aus der Gruppe ausgewählt ist, die aus BF₄⁻, PF₆⁻, ASF₆⁻ und SbF₆⁻ besteht,
(ii) einem Halogenmethyltriazin,
(iii) Tetrabrombisphenol A,
(iv) einer Nitrobenzylesterverbindung und
(v) einer Trifluormethansulfonatverbindung besteht.

8. Resistmaterial nach Anspruch 7, dadurch gekennzeichnet, daß der erwähnte Säurebildner Diphenyl-4-thiophenoxyphenylsulfoniumhexafluorophosphat ist.

9. Resistmaterial nach einem der vorhergehenden Ansprüche 1 bis 8, dadurch gekennzeichnet, daß es ferner einen spektralen Sensibilisator umfaßt.

10. Resistmaterial nach einem der vorhergehenden Ansprüche 1 bis 9, dadurch gekennzeichnet, daß es ferner ein organisches Polymer umfaßt, das eine Hydroxylgruppe hat.

11. Resistmaterial nach einem der vorhergehenden Ansprüche 1 bis 10, dadurch gekennzeichnet, daß es ferner eine Epoxyverbindung umfaßt.

12. Resistmaterial nach einem der Ansprüche 1 bis 11, bei dem das erwähnte Polysiloxan ein Alkoxysilan, das einen Oxiranring hat, allein und wahlweise ein Polysiloxan, das von einem Oxiranring frei ist, umfaßt.

13. Resistmaterial nach einem der Ansprüche 1 bis 12, bei dem das erwähnte Resistmaterial ein negativ arbeitendes Resistmaterial ist.

14. Verfahren zur Herstellung eines Resistmaterials nach einem der Ansprüche 1 bis 13, dadurch gekennzeichnet, daß es die folgenden Schritte umfaßt:
Hydrolysieren eines Alkoxysilans, das einen Oxiranring hat, unter Bildung eines Hydrolysats;
Kondensieren des erwähnten Hydrolysats unter Wasserabspaltung, wobei ein Polysiloxan gebildet wird; und
Vermischen des erwähnten Polysiloxans mit einem Säurebildner.

15. Verfahren zur Herstellung eines Resistmaterials nach einem der Ansprüche 1 bis 13, dadurch gekennzeichnet, daß es die folgenden Schritte umfaßt:
Hydrolysieren eines Alkoxysilans, das einen Oxiranring hat, und eines Alkoxysiloxans, das von einem Oxiranring frei ist, unter Bildung eines Hydrolysats;
Kondensieren des erwähnten Hydrolysats unter Wasserabspaltung, wobei ein Polysiloxan gebildet wird; und
Vermischen des erwähnten Polysiloxans mit einem Säurebildner.

16. Verfahren zur Bildung von Resiststrukturen, dadurch gekennzeichnet, daß es die folgenden Schritte umfaßt:
Aufbringen eines organischen Polymers auf ein Substrat unter Bildung einer unteren Schicht auf dem Substrat;
Auftragen eines Resistmaterials nach einem der vorhergehenden Ansprüche 1 bis 13 auf die erwähnte untere Schicht unter Bildung einer oberen Schicht, so daß auf dem erwähnten Substrat ein Zweischichtresist gebildet wird;
Vorhärten des erwähnten Zweischichtresists;
bildmäßiges Belichten des erwähnten vorgehärteten Zweischichtresists mit Strahlung hoher Energie, wobei ein belichteter Zweischichtresist erhalten wird, der einen belichteten Bereich der erwähnten oberen Schicht und einen unbelichteten Bereich der erwähnten oberen Schicht hat;
Nachhärten des erwähnten belichteten Zweischichtresists, wobei der erwähnte belichtete Bereich der erwähnten oberen Schicht in einem alkalischen Entwickler unlöslich gemacht wird;
Entwickeln des erwähnten belichteten Zweischichtresists mit einem alkalischen Entwickler, wobei der erwähnte unbelichtete Bereich der erwähnten oberen Schicht entfernt wird, während der erwähnte unlöslich gemachte belichtete Bereich der erwähnten oberen Schicht auf der erwähnten unteren Schicht zurückbehalten wird, wobei ein Raum gebildet wird, der dem erwähnten unbelichteten Bereich der erwähnten oberen Schicht entspricht; und
Trockenätzen der erwähnten unteren Schicht unter Anwendung des erwähnten verbleibenden belichteten Bereichs der erwähnten oberen Schicht als Maske zum Entfernen der erwähnten unteren Schicht in einem Bereich unterhalb des erwähnten Raumes, der dem erwähnten unbelichteten Bereich der erwähnten oberen Schicht entspricht.

17. Verfahren nach Anspruch 16, dadurch gekennzeichnet, daß das erwähnte Nachhärten bei einer Temperatur durchgeführt wird, die niedriger ist als die Temperatur, bei der das erwähnte Vorhärten durchgeführt wird.

## Revendications

1. Matériau de réserve, caractérisé en ce qu'il comprend :
(a) un polysiloxane comprenant des groupes hydroxyle dans le polymère ayant des motifs structuraux partiels représentés par les formules (1) à (3) respectivement ci-dessous ; et 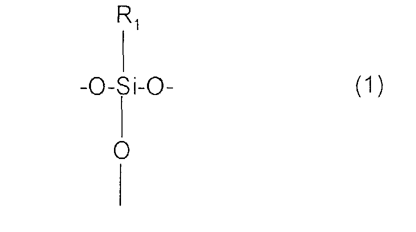 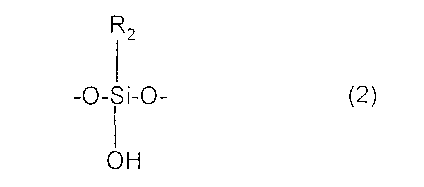 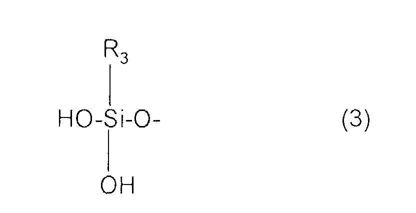 dans lesquelles R₁, R₂ et R₃ qui sont identiques ou différents représentent chacun un groupe organique, tout ou partie d'une pluralité des groupes représentés par R₁, R₂ et R₃ respectivement, ayant un cycle oxirane et les motifs structuraux partiels représentés par les formules (1), (2) et (3) respectivement sont reliés les uns aux autres pour faire des liaisons siloxane ; et
(b) un générateur d'acide.

2. Matériau de réserve suivant la revendication 1, caractérisé en ce que R₁, R₂ et R₃, qui sont identiques ou différents, représentent chacun un groupe alkyle, un groupe alcényle, un groupe cycloalkyle, un groupe phényle ou un groupe anhydride d'acide 4-tétrahydrophtalique.

3. Matériau de réserve suivant la revendication 2, caractérisé en ce que R₁, R₂ et R₃, qui sont identiques ou différents, représentent chacun un groupe 3-glycidoxypropyle, un groupe 2-(3,4-époxycyclohexyl)éthyle, un groupe éthyle, un groupe méthyle, un groupe phényle ou un groupe anhydride d'acide 4-tétrahydrophtalique.

4. Matériau de réserve suivant la revendication 3, caractérisé en ce que R₁, R₂ et R₃, qui peuvent être identiques ou différents, représentent chacun un groupe 2-(3,4-époxycyclohexyl)éthyle ou un groupe phényle.

5. Matériau de réserve suivant l'une quelconque des revendications précédentes, caractérisé en ce que l'abondance des groupes représentés par R₁, R₂ et R₃ et ayant un cycle oxirane est de 20 à 100 % en mole par rapport au total des groupes représentés par R₁, R₂ et R₃.

6. Matériau de réserve suivant l'une quelconque des revendications précédentes 1 à 5, caractérisé en ce que le polysiloxane a une masse moléculaire moyenne en poids de 800 à 10000.

7. Matériau de réserve suivant l'une quelconque des revendications précédentes 1 à 6, caractérisé en ce que le générateur d'acide est un générateur d'acide choisi dans la classe consistant en :
(i) un sel d'onium représenté par la formule (1), (2) ou (3) ci-dessous ;
R'N₂⁺MXₙ⁻ (I)
(R')₂I⁺MXₙ⁻ (II)
(R')₃S⁺MXₙ⁻ (III)
dans lesquelles R' représente un groupe aromatique substitué ou non substitué et MXₙ⁻ représente un groupe choisi parmi BF₄⁻, PF₆⁻, AsF₆⁻ et SbF₆⁻,
(ii) une halométhyltriazine,
(iii) le tétrabromobisphénol A,
(iv) un ester nitrobenzylique et
(v) un trifluorométhanesulfonate.

8. Matériau de réserve suivant la revendication 7, caractérisé en ce que le générateur d'acide est l'hexafluorophosphate de diphényl-4-thiophénoxyphénylsulfonium.

9. Matériau de réserve suivant l'une quelconque des revendications précédentes 1 à 8, caractérisé en ce qu'il comprend en outre un sensibilisateur spectral.

10. Matériau de réserve suivant l'une quelconque des revendications précédentes 1 à 9, caractérisé en ce qu'il comprend en outre un polymère organique ayant un groupe hydroxyle.

11. Matériau de réserve suivant l'une quelconque des revendications précédentes 1 à 10, caractérisé en ce qu'il comprend en outre un composé époxy.

12. Matériau de réserve suivant l'une quelconque des revendications précédentes 1 à 11, dans lequel le polysiloxane comprend un alcoxysilane ayant un cycle oxirane seul et éventuellement un polysiloxane exempt de cycles oxirane.

13. Matériau de réserve suivant l'une quelconque des revendications précédentes 1 à 12, dans lequel le matériau de réserve a une action négative.

14. Procédé de préparation d'un matériau de réserve suivant l'une quelconque des revendications 1 à 13, caractérisé en ce qu'il comprend les stades :
hydrolyse d'un alcoxysilane ayant un cycle oxirane pour former un hydrolysat ;
condensation avec déshydratation de l'hydrolysat en un polysiloxane; et
mélange du polysiloxane à un générateur d'acide.

15. Procédé de préparation d'un matériau de réserve suivant l'une quelconque des revendications 1 à 13, caractérisé en ce qu'il comprend les stades de :
hydrolyse d'un alcoxysilane ayant un cycle oxirane et d'un alcoxysilane exempt de cycle oxirane en un hydrolysat ;
condensation avec déshydratation de l'hydrolysat en un polysiloxane; et
mélange du polysiloxane à un générateur d'acide.

16. Procédé de formation de motifs de réserve, caractérisé en ce qu'il comprend les stades :
application d'un polymère organique sur un substrat pour former une couche de fond sur un substrat ;
application d'un matériau de réserve suivant l'une quelconque des revendications précédentes 1 à 13 sur la couche de fond pour former une couche supérieure, ce qui forme une matière de réserve à deux couches sur le substrat ;
précuisson de la réserve à deux couches ;
exposition de manière à former une image de la réserve à deux couches précuite à un rayonnement de grande énergie pour obtenir une réserve à deux couches exposée ayant une partie exposée de la couche supérieure et une partie non exposée de la couche supérieure ;
post-cuisson de la réserve à deux couches exposée pour rendre la partie exposée de la couche supérieure insoluble dans un révélateur alcalin ;
développement de la réserve à deux couches exposée par un révélateur alcalin pour éliminer la partie non exposée de la couche supérieure, tout en retenant la partie exposée insolubilisée de la couche supérieure sur la couche de fond de manière à former un espace correspondant à la partie non exposée de la couche supérieure ;
gravure à sec de la couche de fond, en utilisant la portion exposée restante de la couche supérieure comme masque pour éliminer la couche de fond dans une région se trouvant en dessous de l'espace correspondant à la partie non exposée de la couche supérieure.

17. Procédé selon la revendication 16, caractérisé en ce qu'il consiste à effectuer la post-cuisson à une température inférieure à celle à laquelle a été effectuée la précuisson.
